# EUROPÄISCHE PATENTSCHRIFT

(11) **EP 4 281 834 B1**
(45) Veröffentlichungstag und Bekanntmachung des Hinweises auf die Patenterteilung: **05.08.2026**
(21) Anmeldenummer: 22703280.2
(22) Anmeldetag: 14.01.2022
(51) Int. Cl.: G03H 1/00, F21V 13/00, G02B 5/32, F21V 8/00, G02B 27/09, G03H 1/02, G03H 1/22, F21S 43/241, G03H 1/26, B60K 35/10, B60K 35/21, B60K 35/22, B60K 35/28, G02B 5/18, H10H 20/855

(54) **MINIATURISIERTE HOLOGRAPHISCHE ANZEIGE**
MINITURISED HOLOGRAPHIC DISPLAY
INDICATEUR HOLOGRAPHIQUE MINIATURISÉ

(30) Priorität: 21.01.2021 DE 102021200543
(43) Veröffentlichungstag der Anmeldung: 29.11.2023
(73) Patentinhaber: Carl Zeiss Jena GmbH, 07745 Jena (DE)
(72) Erfinder: KÜHL, Siemen, 07745 Jena (DE); ERLER, Christoph, 07745 Jena (DE); VOJTISEK, Petr, 07745 Jena (DE)
(74) Vertreter: Leifgen, Matthias
(86) Internationale Anmeldenummer: PCT/EP2022/050782
(87) Internationale Veröffentlichungsnummer: WO 2022/157082

(56) Entgegenhaltungen:
- EP-A1- 3 647 857
- JP-A- H0 939 653
- US-B2- 8 749 371

## Beschreibung

Die Erfindung betrifft eine holographisches Leuchtvorrichtung zur Erzeugung mindestens zweier holographischer Leuchtfunktionen, entsprechend Anspruch 1.

Des Weiteren betrifft die Erfindung ein Fahrzeug mit einer entsprechenden Leuchtvorrichtung sowie eine Verwendung der Leuchtvorrichtung als Anzeige in einem Fahrzeug. Eine Verwendung der Leuchtvorrichtung als LED-Kollimator ist ebenfalls umfasst.

### Hintergrund und Stand der Technik:

Bei der Holografie werden im Gegensatz zu gewöhnlichen Abbildungen, bspw. der Fotografie, neben der Intensität vom abgebildeten Objekt zusätzlich Phasenbeziehungen des vom Objekt kommenden Lichtes abgespeichert. Diese Phasenbeziehungen enthalten zusätzliche räumliche Informationen, wodurch ein dreidimensionaler Eindruck der Abbildung erzeugt werden kann. Dies geschieht mit Hilfe von Interferenz von Lichtstrahlen während der Aufnahme des Objekts. Das Objekt wird mit kohärentem Licht beleuchtet und vom Objekt reflektiert und gestreut. Das entstandene Wellenfeld, die sogenannte Objektwelle, wird mit zu der Objektwelle kohärentem Licht (die sogenannte Referenzwelle - typischerweise von derselben Lichtquelle, z. B. einem Laser) überlagert und die Wellenfelder interferieren als Funktion ihrer Phasenbeziehung miteinander. Das entstehende Interferenzmuster wird bspw. mittels einer lichtempfindlichen Schicht aufgenommen und somit wird auch die in der Phase enthaltene Information gespeichert.

Zur Rekonstruktion beleuchtet man das entstandene Hologramm mit einer zur Referenzwelle identischen bzw. ähnlichen Lichtwelle, welche sodann durch die aufgezeichneten Interferenzmuster gebeugt wird. So kann die ursprüngliche Wellenfront der Objektwelle rekonstruiert werden. Es gibt verschiedene Typen von Hologrammen, z. B. Transmissions- und Reflexionshologramme, die diese Rekonstruktion jeweils entweder in Transmission oder in Reflektion erzeugen. Befindet man sich z. B. bei einem Transmissionshologramm auf einer der Lichtquelle gegenüberliegenden Seite des Hologramms und betrachtet dieses, erscheint das abgebildete Objekt dreidimensional vor einem.

Hologramme sind grundsätzlich dem Publikum schon länger bekannt, z. B. in der Form aufmerksamkeitserregender Produkt- oder Verpackungsaufmachungen oder als Sicherheitsmerkmal auf Kreditkarten und Geldscheinen. Solche Hologramme sind meist qualitativ nicht besonders beeindruckend, da diese auch bei inkohärentem Tageslicht funktionieren sollen. Die Anforderungen an von der Plastizität der dargestellten Objekte her beeindruckenderen Hologrammen ist bezüglich der bei Aufnahme und Wiedergabe verwendeter Lichtquellen deutlich höher bezüglich räumlicher und zeitlicher Kohärenz. Dies steht einer breiten Verwendung von Hologrammen im Alltag häufig im Weg, obwohl Hologramme für eine Vielzahl von Anwendungen aufgrund ihrer starken optischen und ästhetischen Wirkung für eine Vielzahl von Anwendungen geeignet wären. Beispielsweise ist es bei einer Vielzahl von Hologrammen vorteilhaft, zur Rekonstruktion eine annähernd ebene Welle zu verwenden. Eine hierfür wünschenswerte perfekte Kollimation einer perfekten Punktlichtquelle ist in der Realität oftmals nur näherungsweise zu erreichen, wenn nämlich ein Abstand von einer endlich ausgedehnten Lichtquelle groß genug ist, dass diese näherungsweise einer Punktlichtquelle entspricht. Die Anforderungen an den Abstand zwischen Lichtquelle und Hologramm werden dadurch verschärft, dass eine auszuleuchtende Hologrammfläche für viele Anwendungen im Nahbereich eines Betrachters eine gewisse Mindestgröße aufweisen sollte und diese Mindestgröße letztlich vom zur Rekonstruktion verwendeten Lichtstrahl ebenfalls abgedeckt werden muss. Diese Anforderungen stehen einem kompakten Aufbau eines holographischen Elements häufig im Wege. Gleichzeitig ist ein kompakter Aufbau jedoch für eine Vielzahl von potentiellen Anwendungen wünschenswert.

Eine beispielhafte Anwendung von Hologrammen mit solchen Anforderungen kann im Fahrzeug-oder Flugzeugbau gefunden werden. Anzeigen sollen in diesem Bereich eine möglichst klare und gut wahrnehmbare Information wiedergeben, ohne dass die Anzeige der Information zu abstrakt ist. Hier scheint eigentlich ein optimaler Anwendungsbereich für holographische Anzeigen zu liegen, da holographische Anzeigen auch Ortsinformation vermitteln können und so z. B. eine effektivere Warnung vor Hindernissen ermöglicht werden kann. Auch kann die Aufmerksamkeit des Fahrers oder Piloten durch Darstellung eines dreidimensionalen Objekts, z. B. durch eine holographische Warnanzeige erhöht werden. Ein Beispiel für eine solche Anzeige, welche für die Anwendung eines Hologramms besonders geeignet scheint, ist ein sogenannter Spurwechselassistent. Der Spurwechselassistent verwendet geeignete Sensoren, um die Anwesenheit von Fahrzeugen festzustellen, welche sich neben dem Fahrzeug befinden und bei einem Spurwechsel eine Gefahr darstellen könnten. Insbesondere Fahrzeuge im sogenannten toten Winkel werden durch die Sensorik erfasst. Eine Warnung des Fahrers kann optisch durch eine Leuchtanzeige ausgegeben werden, welche sich z. B. im Bereich des Außenspiegels befindet. Gegenüber einer klassischen Anzeige hätte eine holographische Anzeige den Vorteil, dass die Warnwirkung eines dreidimensional durch die Anzeige dargestellten Objekts deutlich höher sein kann und so die Sicherheit erhöht wird. Außerdem kann die Nähe eines anderen Fahrzeugs durch die räumliche Darstellung intuitiver verstanden werden, wodurch Reaktionszeiten verbessert werden können. Einer Integration eines solchen holographischen Anzeigensystems steht im Wege, dass der zu vergebende Bauraum im Fahrzeug häufig sehr knapp ist und mit weiteren technischen Komponenten geteilt werden muss. Insbesondere im Bereich des Außenspiegels ist das Platzangebot knapp, da hier großflächige Komponenten den Sichtbereich des Fahrers stören könnten.

Wünschenswert ist insbesondere auch bei einer Vielzahl von Anzeigen, insbesondere bei einem Spurwechselassistent, dass mehrere, unterschiedliche Information räumlich überlagert dargestellt werden können. Bei diesen unterschiedlichen Informationen kann es sich beispielsweise um verschiedene Warnstufen des Spurwechselassistenten je nach tatsächlicher Kollisionsgefahr mit dem anderen Fahrzeug handeln.

Edge-Lit Hologramme sind Hologramme, die teilweise in einem transparenten Lichtleitkörper integriert sind. Sie werden bevorzugt unter einem großen Winkel beleuchtet. Dabei befindet sich das Hologramm selbst bspw. auf einer Außenfläche des Lichtleitkörpers und die Beleuchtung erfolgt von einer Seite des Lichtleitkörpers, wobei das Licht zwischen Außenflächen im Lichtleiter zum Hologramm geleitet wird. Vorteilhaft ist, dass zum einen die Lichtleitköper ausgelegt sein können, das Licht auch über weitere Entfernungen relativ störungsfrei zu leiten und zum anderen, dass eine gewünschte Ausrichtung von Hologramm zu Beleuchtung im Rahmen der Fertigungstoleranzen durch den Lichtleitkörper automatisch gewährleistet ist. Die gewünschte Ausrichtung hat einen großen Effekt auf die Qualität der holografischen Darstellung und ist daher wichtig. Jedoch benötigen auch Edge-Lit Hologramme aufgrund der oben genannten Anforderungen einen größeren Bauraum. Außerdem ist die Möglichkeit, verschiedene Informationen durch ein einziges Edge-Lit Hologramm anzuzeigen, beschränkt, bspw. ist die Möglichkeit zur Darstellung verschiedener Informationen durch Beleuchtung eines entsprechenden Hologramms aus unterschiedlichen Winkeln aus geometrischen Gründen eingeschränkt, wenn die Beleuchtung aus unterschiedlichen Winkeln von derselben Seite aus erfolgen soll.

Weitere Beschreibungen zum Stand der Technik können in den Dokumenten EP3647857 A1 und US8749371 B2 gefunden werden.

### Aufgabe der Erfindung:

Aufgabe der Erfindung ist es, eine Vorrichtung ohne die Nachteile des Standes der Technik bereitzustellen.

Insbesondere ist es Aufgabe der Erfindung, eine kompakte holografische Leuchtvorrichtung bereitzustellen, welche gleichzeitig holografische Leuchtfunktionen hoher Qualität ermöglicht, dabei mehr als eine Leuchtfunktion realisieren kann und einfach im Aufbau und Herstellung ist. Ebenso ist es Aufgabe der Erfindung, eine solche holographische Leuchtvorrichtung zu einer Anzeige von Informationen in einem Fahrzeug zu verwenden und die Sicherheit auf einfache und preisgünstige Weise zu erhöhen sowie die Bereitstellung eines Fahrzeugs umfassend eine entsprechende holographische Leuchtvorrichtung. Eine weitere Aufgabe der Erfindung ist die Verwendung der holographischen Leuchtvorrichtung als einfacher, verbesserter und preisgünstiger LED-Kollimator in einer messtechnischen Anwendung bzw. Vorrichtung.

### Zusammenfassung der Erfindung:

Die Aufgabe wird durch die Merkmale der unabhängigen Ansprüche gelöst. Bevorzugte Ausführungsformen der Erfindung sind in den abhängigen Ansprüchen beschrieben.

Die Erfindung betrifft eine holographische Leuchtvorrichtung zur Erzeugung mindestens zweier holographischer Leuchtfunktionen, entsprechend Anspruch 1.

Im Folgenden soll zur Einführung beispielhaft eine typische Ausführungsform vorgestellt werden. Das monolithische Bauteil umfasst dabei zwei Edge-Lit Anordnungen (für jeden Kanal eine), welche einander gegenüberliegen. Diese werden über Kreuz von zwei Lichtquellen angeleuchtet. Dabei leuchtet jede Lichtquelle in Richtung der ihr zugeordneten Einkoppelfläche. Innerhalb des Bauteils wird das Licht bis zur gemeinsamen Auskoppelfläche geleitet, z. B. über eine Reflektion an einer Außenfläche des Bauteils. Das Licht der beiden Kanäle trifft dann aus entgegengesetzten azimutalen Richtungen auf die holografische Struktur auf der Auskoppelfläche, wobei diese azimutalen Richtungen bevorzugt in der Ebene der Auskoppelfläche bzw. der holografischen Struktur bestimmt werden. Auch die polaren Winkel unterscheiden sich vorzugsweise, wobei die polaren Winkel bevorzugt in einer Ebene senkrecht zur Auskoppelfläche bzw. zur holografischen Struktur gemessen werden. Die Auskoppelfläche umfasst für jeden Kanal eine holografische Struktur, welche eine holografische Anzeige durch Auskopplung des Lichtes des jeweiligen Kanals erzeugt. Durch die unterschiedlichen azimutalen und polaren Beleuchtungsrichtungen können die Kanäle gut voneinander getrennt werden. Die holografischen Strukturen sind dabei für eine Beleuchtung aus einer anderen Richtung als der dem Kanal zugeordneten Richtung unempfindlich und erzeugen dabei keine Leuchtfunktion. Die Leuchtfunktion kann beispielsweise zwei unterschiedliche Warnstufen einer Spurwechselanzeige umfassen, welche bspw. durch unterschiedliche Farben (Rot oder Gelb, Rot oder Grün o. ä.) realisiert wird.

Trennung der Kanäle bedeutet vorteilhafterweise, dass die Beleuchtung eines Kanals nur die Leuchtfunktion des entsprechenden Kanals erzeugt und im Wesentlichen keine andere Leuchtfunktion eines anderen Kanals.

Die holographische Leuchtvorrichtung zur Erzeugung mindestens zweier holographischer Leuchtfunktionen ist geeignet oder konfiguriert für die Erzeugung mindestens zweier holgraphischer Leuchtfunktionen. Dies ist nicht trivial zu verstehen, wobei eine triviale Interpretation bspw. darin liegen könnte, dass die holographische Leuchtfunktion entweder ein- oder ausgeschaltet ist und dies zwei Leuchtfunktionen darstellt. Eine holographische Leuchtfunktion umfasst eine bestimmte durch das Hologramm erfüllbare Funktionalität. Beispielsweise kann eine holografische Leuchtfunktion durch das abgebildete Objekt, die Farbe des erzeugten Bildes, die Helligkeit des erzeugten Bildes, die Abbildungsrichtung des erzeugten Bildes und/oder den Abbildungsort des erzeugten Bildes umfassen. Ebenso kann durch die Funktionalität in einer Strahlformung von Lichtstrahlen und/oder einer Strahlüberlagerung von Lichtstrahlen unterschiedlicher Lichtquellen bestehen. Dabei ist eine holografische Leuchtfunktion eine durch die holografische Struktur erzeugte Leuchtfunktion. Die so erzeugte Leuchtfunktion kann, aber muss keine dreidimensional anmutenden Aspekte aufweisen, wie sie bevorzugt durch Hologramme erzeugt werden. Die erzeugte Leuchtfunktion kann dabei ein Bild in einer Ebene umfassen oder aber ein Bild mit einem Tiefeneindruck aufweisen. Die holographische Leuchtfunktion kann ein virtuelles und/oder reelles Bild umfassen. Die holographische Leuchtfunktion kann ein innerhalb der Ebene der

Auskopplungsstruktur umfasstes Bild aufweisen (bevorzugt als "in-plane" Hologramm bezeichnet) und/oder ein teilweise bzw. vollständig außerhalb der Auskoppelfläche umfasstes Bild aufweisen. Die mindestens zwei Kanäle für die jeweils zugeordnete Leuchtfunktion sind bevorzugt zunächst einmal im funktionalen Sinn zu verstehen, dass jeder Leuchtfunktion ein Kanal zugeordnet werden kann bzw. umgekehrt und dieser Kanal bei der Erzeugung bzw. Bedienung der Leuchtfunktion eine Rolle spielt. Des Weiteren umfasst ein Kanal Komponenten, welche für die Erzeugung der Leuchtunktion wesentlich sind.

Jeder Kanal umfasst die Komponenten Edge-Lit-Anordnung und Lichtquelle. Edge-Lit Anordnungen wurden bevorzugt vom Grundsatz her bereits vorstehend beschrieben.

Die Lichtquelle kann z. B. mindestens eine LED und/oder mindestens einen Laser umfassen. Die Lichtquelle emittiert vorzugsweise Licht im sichtbaren Spektrum, insbesondere zwischen 380 Nanometer (nm) und 780 nm auf die Wellenlänge des Lichts bezogen. Vorzugsweise können die Lichtquellen der Kanäle unabhängig voneinander ein- und ausgeschaltet werden und weisen eine entsprechende separate elektrische Anschlussmöglichkeit für eine elektrische Energiequelle auf. Die Lichtquelle umfasst bevorzugt keine gesonderte strahlformende Komponente, z. B. keine Linse.

Es kann jedoch auch bevorzugt sein, dass die Lichtquelle mindestens eine strahlformende Komponente umfasst, beispielsweise mindestens eine Linse.

Die Lichtquelle ist bevorzugt mit einer Hauptstrahlungsrichtung in Richtung der Einkoppelfläche angeordnet, insbesondere, wenn die Lichtquelle anisotrope Abstrahlungseigenschaften aufweist.

Die Edge-Lit Anordnung weist mehrere Elemente auf, welche eine Einkoppelfläche und eine Auskoppelfläche umfassen. Die Edge-Lit Anordnung umfasst ein lichtleitendes Element, d.h. einen Lichtleiter. Dieser umfasst mindestens eine äußere Grenzfläche, die den Lichtleiter nach außen abschließt. Diese Grenzfläche umfasst vorzugsweise die Einkoppelfläche und die Auskoppelfläche. Vorzugsweise handelt es sich nicht um eine, sondern um mehrere, einzelne Grenzflächen mit unterschiedlicher Orientierung (z. B. gegeben durch die Flächennormale in einem Punkt der jeweiligen Grenzfläche), von denen jeweils eine die Einkoppelfläche und eine die Auskoppelfläche umfasst. Die Einkoppelfläche(n) und die Auskoppelfläche liegen vorzugsweise an unterschiedlichen Seiten der Edge-Lit Anordnung vor. Die Einkoppelfläche für eine Einkopplung von Licht einer Lichtquelle in die Anordnung ist für diesen Zweck geeignet oder konfiguriert. Dieses Merkmal ist als strukturelles Merkmal zu verstehen in dem Sinn, dass Licht der Lichtquelle des Kanals auch tatsächlich durch diese Einkoppelfläche in die Edge-Lit Anordnung eingekoppelt wird, wenn die Lichtquelle eingeschaltet ist. Hierfür ist die Einkoppelfläche ausgelegt, d. h. bevorzugt, dass sie im Wesentlichen transparent ist für das Licht der Lichtquelle und die Dimensionierung, Formgebung und/oder Orientierung in Bezug auf die Lichtquelle entsprechend vorgenommen wurde, um einen für die Leuchtfunktion des Kanals benötigte Lichtmenge mit gewünschten Eigenschaften in die Edge-Lit Anordnung einzukoppeln.

Die Einkoppelfläche kann eine ebene Fläche umfassen, sie kann jedoch vorzugsweise zur Strahlformung gekrümmt sein.

Vorzugsweise weist die Einkoppelfläche eine Flächennormale in ihrem (geometrischen) Schwerpunkt auf, insbesondere eine Flächennormale einer Tangentialebene der Einkoppelfläche durch deren Schwerpunkt, welche die Flächennormale der Auskoppelfläche schneidet.

Das monolithische Bauteil weist die holografische Struktur auf.

Insbesondere weist die Auskoppelfläche die holografische Struktur auf.

Die holografische Struktur kann jedoch auch in einer Ebene innerhalb und/oder an einer anderen Grenzfläche des Bauteils vorliegen. Licht der Lichtquelle, mit der die holografische Struktur beleuchtet wird, wird wenigstens teilweise durch die Auskoppelfläche aus dem Lichtleitkörper ausgekoppelt Insbesondere wird das Licht, welche die von der holografischen Struktur unter Beleuchtung erzeugte Leuchtfunktion realisiert, durch die Auskoppelfläche aus dem Lichtleitkörper/Bauteil ausgekoppelt. Die holografische Struktur ist hierfür eingerichtet.

Die Lichtquelle ist angeordnet für eine Einstrahlung in die Einkoppelfläche. Dies bedeutet, dass die Lichtquelle der Einkoppelfläche gegenüberliegend angeordnet ist und/oder so ausgerichtet ist, dass eine Hauptstrahlrichtung der Lichtquelle in Richtung der Einkoppelfläche zeigt. Vorzugsweise ist die Lichtquelle gegenüber der Einkoppelfläche so angeordnet, dass bei einem gegebenen Abstand zwischen Lichtquelle und Einkoppelfläche eine eingekoppelte Intensität, welche zur Erzeugung der Leuchtfunktion verwendbar ist, maximiert werden.

Eine Hauptstrahlrichtung, z. B. der Lichtquelle ist bevorzugt eine Richtung, in der eine maximale oder über alle Richtungen gemittelte Intensität des Lichtstrahls vorliegt. Der Begriff Hauptstrahl bzw. Hauptstrahlrichtung bezeichnet dabei bevorzugt den zentralen Strahl eines Strahlenbündels bzw. dessen Richtung. Die Richtung des Hauptstrahls gibt dabei insbesondere die Richtung des Strahlenbündels an. Im Falle eines kollimierten Strahlenbündels verlaufen die übrigen Strahlen des Strahlenbündels im Wesentlichen parallel zur Hauptstrahlrichtung, so dass die Hauptstrahlrichtung vorzugsweise repräsentativ für die Strahlen eines Strahlenbündels ist. Im Falle eines nicht kollimierten Strahlenbündels spannen die Strahlen des Strahlenbündels einen definierten Raumwinkel ein, in dessen Zentrum die Hauptstrahlrichtung verlauft.

Es sind mindestens 2 Kanäle umfasst. Es können beispielsweise 2, 3, 4, 5, 6, 7, 8, 9, 10, 11, 12, 13, 14, 15, 16, 17, 18, 19, 20, ..., 25, ... 30 Kanäle oder mehr umfasst sein.

Die Edge-Lit-Anordnungen der Kanäle sind in einem monolithischen Bauteil umfasst. Das bedeutet, dass die Edge-Lit Anordnungen der einzelnen Kanäle, welche insbesondere für sich genommen funktionsfähig zur Erzeugung der dem Kanal zugeordneten Leuchtfunktion sind, in einem einzigen monolithischen Bauteil integriert vorliegen. Das bedeutet insbesondere, dass das monolithische Bauteil die Einkoppelfläche und die Auskoppelfläche jeder umfassten Edge-Lit Anordnung umfasst. Dabei ist die Auskoppelfläche eine gemeinsame Auskoppelfläche, d. h. insbesondere, dass die die Auskoppelfläche jeder Edge-Lit Anordnungen der verschiedenen Kanäle dieselbe, gemeinsame Auskoppelfläche ist.

Monolithisch bedeutet dabei, aus einem Stück bestehend bzw. einstückig.

Monolithisch kann dabei insbesondere aus einem Stück (z. B. dem Rohmaterial der Lichtleitkörper) gefertigt bedeuten.

Das monolithische Bauteil umfasst die Edge-Lit Anordnungen, welche jedoch untereinander innerhalb des monolithischen Bauteils an den Stellen, an denen sie direkt aneinander angrenzen, keine merklichen Grenzflächen aufweisen und dort insbesondere im Wesentlichen transparent bezüglich des Lichtes der Lichtquellen sind und/oder keine Änderungen ihrer optischen Eigenschaften aufweisen. Die äußeren Grenzflächen des monolithischen Bauteils werden dabei durch die äußeren Grenzflächen der Edge-Lit Anordnungen an den Seiten der Anordnungen gebildet, an denen diese nicht direkt aneinander angrenzen.

Das monolithische Bauteil kann jedoch auch Edge-Lit Anordnungen umfassen. welche untereinander innerhalb des monolithischen Bauteils an den Stellen, an denen sie direkt aneinander angrenzen, Grenzflächen aufweisen, an denen optische Eigenschaften sich ändern, z. B. die Reflektivität.

Die Edge-Lit Anordnungen sind dabei innerhalb des monolithischen Bauteils so zueinander angeordnet, dass die einzelnen Auskoppelflächen der Edge-Lit Anordnungen überlagert sind und eine einzige Auskoppelfläche bilden, die von einer äußeren Grenzfläche des monolithischen Bauteils umfasst sind.

Die Auskoppelfläche kann vorzugsweise eine ebene Fläche sein. Es kann jedoch auch bevorzugt sein, dass die Auskoppelfläche gekrümmt ist.

Die Flächennormale der Auskoppelfläche ist dabei eine Flächennormale in dem Punkt, in dem diese die Auskoppelfläche berührt bzw. schneidet. Sie ist dabei insbesondere senkrecht zu einer in diesem Punkt anliegenden Tangentialebene.

Die Flächennormale berührt/schneidet die Auskoppelfläche im (geometrischen) Schwerpunkt der Auskoppelfläche.

Jede Edge-Lit Anordnung umfasst eine Einkoppelfläche, insbesondere eine eigene bzw. separate Einkoppelfläche.

Jeder Kanal ist entlang eines azimutalen Anordnungswinkels um eine Flächennormale der Auskoppelfläche angeordnet, bevorzugt um die Flächennormale rotiert angeordnet. Die Anordnung bzw. Ausrichtung des Kanals wird vorzugsweise anhand einer Anordnungsrichtung des jeweiligen Kanals festgestellt, wobei diese Anordnungsrichtung für jeden umfassten Kanal in gleicher Weise definiert ist, damit die Anordnung einheitlich für alle Kanäle definiert ist. Vorzugsweise handelt es sich insbesondere um eine Hauptstrahlrichtung des Lichtes innerhalb der Anordnung jedes Kanals oder um eine der Hauptstrahlrichtung um 180° entgegengesetzte Richtung. Es handelt sich insbesondere um eine Richtung, entlang derer die Komponenten und/oder Elemente des Kanals/der Edge-Lit Anordnung angeordnet sind oder um eine dieser Richtung um 180° entgegengesetzten Richtung.

Die Flächennormale verläuft auf beiden Seiten der Auskoppelfläche, sowohl außerhalb der Edge-Lit Anordnung bzw. des monolithischen Bauteils als auch innerhalb der Edge-Lit Anordnung bzw. des monolithischen Bauteils. Dem Fachmann ist klar, dass aufgrund der Anforderung, dass jeder Kanal entlang eines azimutalen Anordnungswinkels um die Flächennormale der Auskoppelfläche rotiert angeordnet vorliegt, diese bevorzugt qua Definition um die Flächennormale innerhalb der Edge-Lit Anordnung bzw. des monolithischen Bauteils angeordnet vorliegen.

Der azimutale Anordnungswinkel ist dabei in Bezug auf die Auskoppelfläche definiert bzw. bei einer gekrümmten Auskoppelfläche um eine Tangentialebene im Schnittpunkt bzw. Berührungspunkt der Flächennormalen der Auskoppelfläche mit der Auskoppelfläche. Dabei kann zur Benennung des Winkels vorzugsweise eine Referenzrichtung als Richtung angenommen werden, von der aus der azimutale Anordnungswinkel bestimmt wird. Diese kann beispielsweise durch den azimutalen Anordnungswinkel einer bestimmten Edge-Lit Anordnung gegeben sein. Diese Referenzrichtung entspricht dann vorzugsweise einem azimutalen Anordnungswinkel von 0°. Die Richtung bezüglich der Referenzrichtung, in der der azimutale Anordnungswinkel gemessen wird, ist bevorzugt gegen den Uhrzeigersinn, kann jedoch ebenso bevorzugt im Uhrzeigersinn erfolgen. Vorzugsweise ist der absolute azimutale Winkel für das Verständnis der Anordnung weniger entscheidend als der Relativwinkel zwischen den Kanälen. Das monolithische Bauteil weist mindestens eine holografische Struktur auf, welche eingerichtet ist für eine Erzeugung der Leuchtfunktion des jeweiligen Kanals unter einer Beleuchtung durch die Lichtquelle des Kanals. Die mindestens eine holgrafische Struktur ist dabei so realisiert und/oder angeordnet, dass bei einer eingeschalteten Lichtquelle des Kanals, deren Licht die holografische Struktur zumindest teilweise beleuchtet, die dem Kanal zugeordnete holografische Leuchtfunktion erzeugt wird. Es ist bevorzugt, dass die holografische Struktur bei einer Beleuchtung durch eine Lichtquelle eines anderen Kanals im Wesentlichen nicht die holografische Leuchtfunktion des jeweiligen anderen Kanals oder des eigenen Kanals erzeugen, insbesondere gar keine holografische Leuchtfunktion erzeugen. Dabei kann es sich um eine einzige holografische Struktur handeln, welche die Leuchtfunktion der umfassten Kanäle beinhaltet und so gestaltet ist, dass sie bei Beleuchtung des jeweiligen Kanals (z. B. aus der entsprechenden Richtung und/oder mit dem entsprechenden Spektralbereich) die Leuchtfunktion des jeweiligen Kanals erzeugt und vorzugsweise nur diese aufgrund der Beleuchtung durch die Lichtquelle des jeweiligen Kanals erzeugt. Es kann sich jedoch bevorzugt um mehrere holografische Strukturen handeln, insbesondere pro Kanal mindestens einer holografischen Struktur, welche entsprechend den vorhergehenden Erklärungen funktioniert bzw. eingerichtet ist. Es können vorzugsweise auch mehrere Kanäle gleichzeitig durch Beleuchtung durch die Lichtquelle des jeweiligen Kanals mehrere Leuchtfunktionen gleichzeitig erzeugt werden. Bevorzugt sind die den jeweiligen Kanälen zugeordneten holografischen Strukturen übereinander, insbesondere stapelweise übereinander, in einem sogenannten Stack angeordnet.

In einer alternativen Ausgestaltung liegen die den jeweiligen Kanälen zugeordneten holografischen Strukturen in einer einzigen holografischen Struktur vor, insbesondere in einer sogenannten Hologrammfolie, in der sie gemeinsam belichtet wurden. Eine solche holografische Struktur wird vorzugsweise auch als sogenanntes Multiplexhologramm bezeichnet.

Bevorzugt weist die Auskoppelfläche die holografische Struktur auf.

Es kann jedoch auch bevorzugt sein, dass die holografische Struktur innerhalb des monolithischen Bauteils oder an einer anderen Grenzfläche des monolithischen Bauteils angeordnet ist. Dabei ist die holografische Struktur in einer Parallelebene zur Auskoppelfläche angeordnet. Wenn die holografische Struktur an einer anderen Grenzfläche des monolithischen Bauteils untergebracht ist, handelt es sich um eine parallele bzw. der Auskoppelfläche gegenüberliegende Grenzfläche. Es kann bevorzugt sein, dass die Ebene, in der sich die holgrafische Struktur erstreckt, um eine Ebene mit im Wesentlichen gleichen Abmessungen wie die Auskoppelfläche handelt, insbesondere um eine zur Auskoppelfläche deckungsgleiche oder kongruente Ebene.

Die holografische Struktur ist also parallel zur Auskoppelfläche. Der Fachmann weiß. dass Parallelität nicht nur auf gerade, sondern auch gekrümmte Ebenen umfassen kann, welche parallel sind, also insbesondere auf die gleiche Art gekrümmt sind und sich nicht schneiden bzw. nicht schneiden würden, wenn sie beliebig vergrößert würden, bzw. nur im Unendlichen schneiden würden.

Der Fachmann weiß, dass Parallelität auch bedeuten kann, dass die holografische Struktur auf der Auskoppelfläche vorliegt und von dieser umfasst ist.

Überwiegend parallel bedeutet vorzugsweise, dass zumindest die Tangentialebenen im geometrischen Schwerpunkt der Auskoppelfläche und der holografischen Struktur parallel sind, soweit es sich bei zumindest einer der beiden Flächen Auskoppelfläche und Anordnungsebene der holografischen Struktur um eine gekrümmte Fläche handelt.

Wenn die holgrafische Struktur von der Auskoppelfläche umfasst ist, erstreckt sich die holografische Struktur bevorzugt über einen Großteil (mindestens 50%) der Auskoppelfläche. Es kann besonders bevorzugt sein, dass sich die holografische Struktur im Wesentlichen über die gesamte Auskoppelfläche erstreckt.

Unabhängig von dem Ort der Anordnung der holografischen Struktur ist die Flächennormale der Auskoppelfläche ebenso eine Flächennormale der Anordnungsebene der holografischen Struktur ist. Wenn diese Anordnungsebene gekrümmt ist, ist die Flächennormale insbesondere eine Flächennormale der Tangentialebene im geometrischen Schwerpunkt der Anordnungsebene. Die Formulierung bedeutet, dass die holografische Struktur zur Auskoppelfläche parallel ist, dass die holografische Struktur senkrecht zur Flächennormalen der Auskoppelfläche angeordnet ist.

Die holografische Struktur ist vorzugsweise eine transmissive holografische Struktur, insbesondere, wenn diese von der Auskoppelfläche umfasst ist.

Es kann sich jedoch ebenfalls um eine reflexive holografische Struktur handeln, welche synonym auch als reflektive holografische Struktur bezeichnet werden kann.

In einer bevorzugten Ausführungsform der Erfindung ist die holographische Leuchtvorrichtung eine holographische Anzeige. Das bedeutet bevorzugt, dass die holografische Leuchtvorrichtung eine Anzeigenfunktion besitzt, z. B. für einen vorstehend beschriebenen Spurwechselassistenten, bei dem mindestens zwei Warnstufen umfasst sind, welche durch jeweils eine holographische Leuchtfunktion realisiert werden. Auch eine Wam- oder Temperaturanzeige, bevorzugt in einem Fahrzeug, z. B. eines Bedienelementes in einem Kraftfahrzeug, kann so realisiert werden.

So kann eine extrem kompakte holographische Leuchtvorrichtung realisiert werden, welches einfach zu fertigen ist und keine Justage benötigt. Es können bspw. verschiedenfarbige holografische Leuchtfunktionen in einer einzigen miniaturisierten holographischen Anzeige erzeugt werden.

In der beanspruchten Erfindung weist die Edge-Lit-Anordnung jedes Kanals als weiteres Element eine Reflektionsfläche auf, welche eingerichtet ist für eine direkte reflektive Beleuchtung der holografischen Struktur durch eingekoppeltes Licht.

Eine Reflektionsfläche ist vorzugsweise eine von der Edge-Lit Anordnung umfasste Fläche, welche geeignet ist, die Lichtstrahlen der Lichtquelle im Wesentlichen zu reflektieren. Das bedeutet insbesondere, dass sie die Strahlen unter dem jeweiligen Reflektionswinkel und/oder des jeweiligen Frequenzspektrums im Wesentlichen reflektiert. Das kann vorzugsweise eine Reflektion von mindestens 50% der auf die Reflektionsfläche auftretenden Lichts bedeuten, stärker bevorzugt mindestens 60%, noch stärker bevorzugt mindestens 70 % und insbesondere mindestens 80 %. Es handelt sich bei der Reflektion vorteilhafterweise im Wesentlichen um eine gerichtete Reflektion im Gegensatz zu einer diffusen Reflektion. Es kann jedoch ein gewisser Grad an diffuser Reflektion zusätzlich zur gerichteten Reflektion erwünscht sein für eine Homogenisierung des Lichtes. Bei der Reflektionsfläche kann es sich bspw. um eine äußere Grenzfläche der Edge-Lit Anordnung handeln. Die Reflektionsfläche ist somit vom monolithischen Bauteil umfasst. Es kann sich dabei bevorzugt um eine äußere Grenzfläche des monolithischen Bauteils handeln. Es kann sich bei der Reflektionsfläche jedoch auch um eine äußere Grenzfläche der Edge-Lit Anordnung handeln, welche vom monolithischen Bauteil umfasst ist, jedoch keine äußere Grenzfläche des monolithischen Bauteils ist, bspw. eine Grenzfläche zwischen zwei Edge-Lit Anordnungen im Inneren des monolithischen Bauteils.

Die Reflektionsfläche kann vorzugsweise eine ebene Fläche sein. Es kann sich jedoch auch um eine gekrümmte Fläche zur Strahlformung des eingekoppelten Lichts handeln. Vorzugsweise weist die Reflektionsfläche eine Flächennormale in ihrem Schwerpunkt auf, insbesondere einer Tangentialebene der Reflektionsfläche durch deren Schwerpunkt, welche die Flächennormale der Auskoppelfläche schneidet.

Jede Edge-Lit Anordnung umfasst eine Reflektionsfläche, insbesondere eine eigene bzw. separate Reflektionsfläche.

Die Reflektion kann auf einer Totalreflektion aufgrund einer Änderung der Brechzahl an der Reflektionsfläche von einer höheren zu einer niedrigeren Brechzahl und/oder aufgrund der Materialeigenschaften der Reflektionsfläche basieren, welche einen hohen Reflexionsgrad für das Frequenzspektrum der Lichtquelle aufweist. Ein solcher Reflexionsgrad kann beispielsweise durch eine entsprechende Beschichtung, z. B. durch ein Metall, insbesondere Aluminium, Silber und/oder Gold, erzielt werden.

Die Reflektionsfläche ist eingerichtet für eine direkte reflektive Beleuchtung der holografischen Struktur durch eingekoppeltes Licht, das bedeutet, dass diese Fläche so angeordnet und/oder gestaltet ist, dass das in die Edge-Lit Anordnung eingekoppelte Licht, welches durch die Einkoppelfläche eingekoppelt ist und insbesondere Licht der Lichtquelle des Kanals umfasst, diese Reflektionsfläche überwiegend (vorzugsweise mind. 50% des eingekoppelten Lichtes des Kanals) erreichen kann, vorzugsweise auf direktem Weg von der Einkoppelfläche zur Reflektionsfläche und dort in der genannten Weise reflektiert wird.

Eine direkte reflektive Beleuchtung der holografischen Struktur ist bevorzugt eine Beleuchtung, welche ohne eine weitere Reflektion bzw., wenn es sich bei der holographischen Struktur um ein Reflexionshologramm handelt durch maximal eine Reflektion an der Auskoppelfläche die holografische Struktur beleuchtet.

Durch Verwendung einer Reflektionsfläche kann ein besonders vorteilhafter Strahlverlauf erzielt werden, welcher trotz einer kompakten Bauform der Vorrichtung einen relativ langen Verlauf innerhalb der Vorrichtung hat und so besonders gut geformt und kontrolliert werden kann. der beanspruchten Erfindung weist die Edge-Lit-Anordnung jedes Kanals als weiteres Element eine Reflektionsfläche auf, welche eingerichtet ist für eine Strahlfaltung (vorzugsweise: einfach) der Beleuchtung bzw. des Beleuchtungslichtes ( des eingekoppelten Lichtes) der holografischen Struktur und für eine direkte reflektive Beleuchtung der holografischen Struktur durch eingekoppeltes Licht, wobei bevorzugt die Beleuchtungen der verschiedenen Kanäle auf der holographischen Struktur im Wesentlichen überlappen.

In einer bevorzugten Ausführungsform der Erfindung ist die Reflektionsfläche eingerichtet für eine direkte reflektive Beleuchtung der holografischen Struktur entlang des azimutalen Anordnungswinkels, wobei die holografische Struktur eingerichtet ist für die Erzeugung der Leuchtfunktion des Kanals bei der reflektiven Beleuchtung entlang des azimutalen Anordnungswinkels.

Die Reflektionsfläche ist insbesondere eingerichtet für eine direkte reflektive Beleuchtung der holografischen Struktur durch eingekoppeltes Licht entlang des (vorzugsweise dem Kanal zugeordneten) azimutalen Anordnungswinkels. Damit ist bevorzugt der azimutale Anordnungswinkel der Edge-Lit Anordnung gemeint, zu der die Reflektionsfläche zugehörig ist. Vorteilhafterweise ergibt sich dies dadurch, dass die Edge-Lit Anordnung entlang des azimutalen Anordnungswinkels angeordnet ist und somit auch die Reflektionsfläche.

Beleuchtung entlang des azimutalen Anordnungswinkels bezeichnet bevorzugt eine Beleuchtung mit einer Hauptstrahlrichtung, welche zum azimutalen Anordnungswinkel parallel oder mit diesem deckungsgleich ist. Der azimutale Anordnungswinkel wird insbesondere von der Flächennormalen der Auskoppelfläche ausgemessen und gibt bevorzugt die auf die Auskoppelfläche bzw. holografische Struktur projizierte Orientierung der Hauptstrahlrichtung der von der Reflektionsfläche erfolgenden Beleuchtung an. Die Hauptstrahlrichtung der direkten reflektiven Beleuchtung bzw. deren Projektion auf die Auskoppelfläche bzw. holografische Struktur kann in die Richtung des azimutalen Anordnungswinkels oder in die umgekehrte Richtung weisen. Die Konvention, welche Beleuchtungsrichtung als entlang des azimutale Anordnungswinkels gilt, wird vorzugsweise so festgelegt, dass eine Beleuchtung entlang eines azimutalen Anordnungswinkels durch eine Reflektionsfläche verursacht wird, welche zu einer entlang des azimutalen Anordnungswinkels angeordneten Edge-Lit-Anordnung gehört. So verursachen zwei zueinander um 180° angeordnete Edge-Lit Anordnungen bevorzugt zwei Beleuchtungsrichtungen der Auskoppelfläche bzw. der holografischen Struktur, welche sich ebenfalls um 180° unterscheiden.

Die reflektive Beleuchtung entlang des Anordnungswinkels kann beispielsweise dadurch erzielt werden, dass die Reflektionsfläche entlang einer Ebene angeordnet vorliegt, die senkrecht zum azimutalen Anordnungswinkel ist.

Das Licht weist somit vorteilhafterweise nach der Reflektion einer zu einer entlang eines azimutalen Anordnungswinkels angeordneten Edge-Lit Anordnung gehörigen Reflektionsfläche eine Hauptstrahlrichtung auf mit einer Projektion auf die Auskoppelfläche/die holografische Struktur entlang des azimutalen Anordnungswinkels. Die bspw. sich auf der Auskoppelfläche befindliche holografische Struktur wird somit aus mit einer Hauptstrahlrichtung entlang des horizontalen Anordnungswinkels beleuchtet. Somit erfolgt vorteilhafterweise die Beleuchtung der jeweiligen holografischen Struktur jedes Kanals aus einer anderen Richtung in Bezug auf den Azimutwinkel mit der Auskoppelfläche bzw. der holografischen Struktur.

Die holografische Struktur ist vorzugsweise eingerichtet für die Erzeugung der Leuchtfunktion des Kanals bei der reflektiven Beleuchtung entlang des azimutalen Anordnungswinkels. Dies bedeutet bevorzugt, dass die holografische Struktur bei einer Beleuchtung mit einer Hauptstrahlrichtung entlang des azimutalen Anordnungswinkels, insbesondere wie vorstehend beschrieben, die Leuchtfunktion erzeugt.

Insbesondere ist die holografische Struktur eingerichtet, die Leuchtfunktion nur bei einer Beleuchtung entlang des azimutalen Anordnungswinkels zu erzeugen. Das bedeutet vorzugsweise, dass die holografische Struktur bei einer Beleuchtung entlang einer anderen Richtung als entlang des azimutalen Anordnungswinkels im Wesentlichen keine Leuchtfunktion erzeugt.

Der Fachmann weiß, wie er entsprechende holografische Strukturen durch Beleuchtung aus entsprechenden Richtungen bei der Aufnahme herstellt.

Dabei kann bevorzugt sein, dass die holografische Struktur einen Toleranzwinkelbereich um den azimutalen Anordnungswinkel herum aufweist, in dem die holografische Struktur ebenfalls die erwünschte Leuchtfunktion erzeugt. Dies ist insbesondere vorteilhaft, da die Beleuchtung meistens ein gewisses azimutales Winkelspektrum um eine Hauptstrahlrichtung herum aufweist. Der Toleranzwinkelbereich ist vorzugsweise so gewählt, dass Licht des jeweiligen Kanals im Toleranzwinkelbereich vorhanden ist, jedoch im Wesentlichen kein Licht eines anderen Kanals.

Begriffe wie "im Wesentlichen", "ungefähr", "etwa", "ca." etc. beschreiben bevorzugt einen Toleranzbereich von weniger als ± 40%, bevorzugt weniger als ± 20%, besonders bevorzugt weniger als ± 10 %, noch stärker bevorzugt weniger als ± 5% und insbesondere weniger als ± 1 %. Ähnlich beschreibt bevorzugt Größen, die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Aufgrund der winkelselektiven Beleuchtung und/oder Erzeugung der Leuchtfunktion kann eine verbesserte Trennung der Kanäle und deren Leuchtfunktion in einem sehr kompakten Bauteil vorgenommen werden, welches lediglich eine einzige Auskoppelfläche aufweist und monolithisch gestaltet ist. Verschiedene Kanäle, deren Lichtquellen und/oder Leuchtfunktionen können beispielsweise spektral sehr dicht beisammen liegen bzw. überlappen (Beispielsweise kann es drei Kanäle geben mit einer jeweiligen Leuchtfunktion in gelb, grün und rot, wobei diese teilweise spektral dicht beieinander liegen oder überlappen oder es gibt drei Kanäle, deren Leuchtfunktionen alle rot sind). Dabei können die holografischen Strukturen ggf. auch für Wellenlängen der jeweils anderen Lichtquelle des anderen Kanals effizient sein. Durch die bevorzugte Ausführungsform kann verhindert werden, dass die Lichtquelle des einen Kanals die holografische Struktur des anderen Kanals zu Erzeugung einer Leuchtfunktion anregt.

In einer weiteren bevorzugten Ausführungsform der Erfindung ist die Reflektionsfläche eingerichtet für eine direkte reflektive Beleuchtung der Auskoppelfläche bzw. der holografischen Struktur durch eingekoppeltes Licht in einem Polarwinkel, bevorzugt in einem dem Kanal zugeordneten Polarwinkel, wobei die holografische Struktur bevorzugt eingerichtet ist für die Erzeugung der Leuchtfunktion bei einer Beleuchtung in dem Polarwinkel, bevorzugt in dem Polarwinkel des Kanals.

Analog zu einer vorstehend beschriebenen Reflektionsfläche, welche eingerichtet ist für eine Beleuchtung entlang eines azimutalen Anordnungswinkels kann die Reflektionsfläche für eine Beleuchtung der Auskoppelfläche bzw. der holografischen Struktur in einem dem Kanal zugeordneten Vertikalwinkel bzw. Polarwinkel eingerichtet sein. Vorzugsweise sind Polarwinkel und Vertikalwinkel synonym verwendbare Begriffe. Der Polarwinkel kann bspw. durch das Symbol Θ gekennzeichnet werden.

Die Reflektionsfläche ist vorzugsweise innerhalb des Bauteils von der Auskoppelfläche aus gesehen "oberhalb" der Auskoppelfläche angeordnet. Oberhalb ist bevorzugt nicht als absolut definierter Begriff zu verstehen, sondern als Begriff, welcher die relative Anordnung verschiedener Elemente und Komponenten innerhalb der Vorrichtung beschreibt. Bei dieser Betrachtung ist die Auskoppelfläche vorzugsweise als Unterseite der Vorrichtung anzusehen und die Vertikalrichtung in Bezug auf die Vorrichtung ist bevorzugt entlang bzw. parallel der Flächennormalen zur Auskoppelfläche definiert. Dabei ist die Reflektionsfläche vorzugsweise bezüglich der Vertikalrichtung so geneigt und vorzugsweise so geformt, dass eingekoppelte Lichtstrahlen des Kanals mit einer Hauptstrahlrichtung in einem dem Kanal zugeordneten Polarwinkel in Bezug auf die Flächennormale der Auskoppelfläche (bzw. einer Parallelen hierzu) die Auskoppelfläche bzw. die holografische Struktur beleuchten. Dabei wird der Polarwinkel vorzugsweise gegen den Uhrzeigersinn ausgehend von der Flächennormalen zur Auskoppelfläche als Winkel zwischen der Hauptstrahlrichtung der Beleuchtung und der Flächennormalen gemessen. Dabei wird vorzugsweise immer in die Richtung gemessen, in der der Winkel am kleinsten ist, wobei je nachdem, ob diese Richtung gegen den Uhrzeigersinn oder mit dem Uhrzeigersinn verläuft, als Konvention ein positiver oder ein negativer Winkel gemessen wird. Die Konvention kann vorzugsweise auch so sein, dass im Uhrzeigersinn gemessen wird.

Dabei ist vorzugsweise die Feststellung, ob ein gemessener Winkel entgegen dem Uhrzeigersinn oder mit dem Uhrzeigersinn gemessen wird, abhängig von der Betrachtungsseite der Ebene, in der der Polarwinkel liegt. Dies ist jedoch vorzugsweise ebenfalls bloße Konvention, wichtig ist vielmehr, dass für die Hauptstrahlrichtung der Beleuchtungsrichtung zweier Kanäle, deren Polarwinkel in der gleichen Ebene vorliegen (das bedeutet insbesondere, dass die beiden Kanäle sich gegenüberliegen), mit der gleichen Konvention, also in der gleichen Richtung gemessen werden. Dies ist bevorzugt wichtig für die Feststellung der Polarwinkel zweier gegenüberliegender Edge-Lit Anordnungen, welche vorzugsweise einen azimutalen Anordnungswinkel aufweisen, welcher sich im Wesentlichen um 180° unterscheidet. Somit beleuchten vorzugsweise zwei einander gegenüberliegende Kanäle mit zwei gegenüberliegenden Edge-Lit Anordnungen die Auskoppelfläche/die holografische Struktur entlang zweier um 180° unterschiedlicher azimutaler Anordnungswinkel und in zwei unterschiedlichen Polarwinkeln. Es kann für diese Winkel, bei grds. gleichem Aufbau beider Edge-Lit Anordnungen gelten, dass Θ₁ = -Θ₂.

Die holografische Struktur ist bevorzugt eingerichtet für die Erzeugung der Leuchtfunktion bei einer Beleuchtung in dem Polarwinkel des Kanals.

Insbesondere ist die holografische Struktur eingerichtet, die Leuchtfunktion nur bei einer Beleuchtung in dem Polarwinkel des Kanals zu erzeugen. Das bedeutet vorzugsweise, dass die holografische Struktur bei einer Beleuchtung aus einer anderen Richtung als im Polarwinkel des Kanals entlang im Wesentlichen keine Leuchtfunktion erzeugt.

Der Fachmann weiß, wie er entsprechende holografische Strukturen durch Beleuchtung aus entsprechenden Richtungen bei der Aufnahme herstellt.

Dabei kann bevorzugt sein, dass die holografische Struktur einen Toleranzwinkelbereich um den Polarwinkel herum aufweist, in dem die holografische Struktur ebenfalls die erwünschte Leuchtfunktion erzeugt. Dies ist insbesondere vorteilhaft, da die Beleuchtung meistens ein gewisses Polarwinkelspektrum um eine Hauptstrahlrichtung herum aufweist. Der Toleranzwinkelbereich ist vorzugsweise so gewählt, dass Licht des jeweiligen Kanals im Toleranzwinkelbereich vorhanden ist, jedoch im Wesentlichen kein Licht eines anderen Kanals.

Es kann bevorzugt sein, dass jeder Kanal einen anderen Polarwinkel aufweist. Dann ist eine Trennung der Kanäle hierdurch verbessert möglich. Insbesondere in Verbindung mit einer Trennung der Kanäle über die Beleuchtung entlang verschiedener azimutaler Anordnungswinkel ist eine verbesserte Trennung der Kanäle möglich.

Es kann bevorzugt sein, dass mehrere Kanäle den zumindest betragsmäßig gleichen Polarwinkel aufweisen. Jedoch weisen zumindest zwei bezüglich des azimutalen Anordnungswinkels gegenüberliegende Kanäle mit einem betragsmäßig gleichen Polarwinkel bevorzugt einen (vom Vorzeichen her) unterschiedlichen Polarwinkel auf, s. o. Ansonsten unterscheiden sich auch Kanäle mit einem betragsmäßig gleichen polaren Beleuchtungswinkel vorzugsweise in Bezug auf die azimutale Beleuchtungsrichtung und können somit gut voneinander separiert werden durch eine entsprechend selektive holografische Struktur. So kann eine verbesserte Trennung der Kanäle, insbesondere für gegenüberliegende Kanäle erreicht werden.

Dem Fachmann ist klar, dass je nachdem, wie das Toleranzwinkelspektrum der holografischen Struktur bezüglich der Beleuchtung entlang des azimutalen Anordnungswinkels oder der Beleuchtung im Polarwinkel ausgeprägt ist, nur einer der beiden Winkel für die Trennung der Kanäle entscheidend sein kann oder aber beide Winkel. Es kann besonders bevorzugt sein, dass für jede holografische Struktur bezüglich der Beleuchtung des azimutalen Anordnungswinkels und für die Beleuchtung im Polarwinkel jeweils ein Winkel (bevorzugt mit einem Toleranzwinkelspektrum) definiert ist, für den die holografische Struktur die Leuchtfunktion erfüllt.

Durch ein Winkelmultiplexing entlang zweier "Winkeldimensionen" kann eine besonders gute Trennung der Leuchtfunktionen der Kanäle und eine ideale räumliche Anordnung der Kanäle zugleich erzielt werden, wodurch eine hohe optische Qualität der Leuchtfunktion und eine geringe Abmessung der Vorrichtung bei eine Mehrzahl von Kanälen erzielt werden kann.

Es ist bevorzugt, dass die reflektive Beleuchtung der Auskoppelfläche bzw. der holografischen Struktur mit einem Polarwinkel zwischen 40° und 60°, insbesondere 50° erfolgt.

Es ist insbesondere bevorzugt, dass die reflektive Beleuchtung der Auskoppelfläche unter einem Winkel größer als ein kritischer Winkel der Totalreflektion erfolgt. Die vorstehend genannten Winkel erfüllen vorzugsweise diese Bedingung.

Dabei ist bevorzugt, dass die holografische Struktur eine entsprechend angepassten Rekonstruktionswinkel aufweist, unter dem die Leuchtfunktion erzeugt wird.

Insbesondere wird das Hologramm unter kleineren Winkeln in Bezug auf die Flächennormale rekonstruiert (das bedeutet vorzugsweise, dass die Auskoppelfläche bzw. die holografische Struktur unter kleinen Polarwinkeln beleuchtet wird. Hierdurch kann vorzugsweise Bauraum in eine laterale, zur Flächennormalen der Auskoppelfläche senkrechten Richtung gespart werden.

In einer weiteren bevorzugten Ausführungsform der Erfindung sind die Lichtquelle, die Einkoppelfläche und/oder die Reflektionsfläche eingerichtet für eine Beleuchtung der holografischen Struktur mit einem Winkelspektrum in einer azimutalen Richtung kleiner als 5°, insbesondere kleiner als 2°.

Ein Winkelspektrum in einer azimutalen Richtung meint insbesondere das azimutale Winkelspektrum, also das Winkelspektrum in der Ebene (bzw. auf die Ebene projiziert), in der der azimutale Winkel gemessen wird.

In einer weiteren bevorzugten Ausführungsform der Erfindung sind die Lichtquelle, die Einkoppelfläche und/oder die Reflektionsfläche eingerichtet für eine Beleuchtung der holografischen Struktur mit einem Winkelspektrum in einer polaren Richtung kleiner als 5°, insbesondere kleiner als 2°.

Das Winkelspektrum in polarer Richtung ist vorzugsweise analog zum Winkelspektrum in azimutaler Richtung definiert.

Hierdurch können Verschmierungen des Hologramms bzw. Geisterbilder bei der Rekonstruktion des Hologramms vermindert werden.

In einer weiteren bevorzugten Ausführungsform der Erfindung sind die Lichtquelle, die Einkoppelfläche und/oder die Reflektionsfläche eingerichtet für eine Beleuchtung der holografischen Struktur mit einem Winkelspektrum, welches weniger als 5 °, insbesondere weniger als 2° von einem Referenzwinkelspektrum abweicht, wobei das Referenzwinkelspektrum vorzugsweise ein Winkelspektrum zwischen 0 ° und 40 ° umfasst.

Referenzwinkelspektrum bezeichnet dabei vorzugsweise das Winkelspektrum der Referenzwelle bei der Erzeugung der holografischen Struktur.

Vorzugsweise wird durch das Referenzwinkelspektrum, welches bei der Herstellung der holografischen Struktur verwendet wird (s. o. "Referenzwelle"), eine Art Toleranzwinkelbereich der holografischen Struktur vorgegeben, innerhalb dessen durch Beleuchtung eine gewünschte Leuchtfunktion durch die holografische Struktur erzeugt wird. Dabei kann es bevorzugt sein, einen größeren Toleranzbereich zu haben und dementsprechend ein größeres Referenzwinkelspektrum, welches bevorzugt näher an 40° liegt, z. B. zwischen 25° und 40°. Dies lockert sowohl die Anforderungen an die Referenzwelle bei der Herstellung der holografischen Struktur als auch die Anforderungen an das Winkelspektrum der Beleuchtung, wodurch wiederum die Anforderungen bei der Genauigkeit der Fertigung des monolithischen Bauteils bzw. bei der Anordnung der Lichtquelle in Bezug auf das Bauteil gelockert werden. So kann die Herstellung insgesamt verbilligt werden. Es kann jedoch auch bevorzugt sein, dass dieser Toleranzbereich und somit das Referenzwinkelspektrum eher klein und somit näher an 0° liegt, z. B. zwischen 0° und 10°. So kann insbesondere die optische Qualität der Leuchtfunktion verbessert werden.

Ein maximal erwünschtes Winkelspektrum kann insbesondere vom Hologrammmotiv bzw. der "Tiefe" des Hologramms abhängen. Liegt das Bild z. B. in der Ebene der Auskoppelfläche, so ist ein größeres Winkelspektrum akzeptabel, als wenn das Bild (oder ein Teil des Bildes) z. B. weit davor oder dahinter erscheint.

Vorzugsweise weicht dabei die Hauptstrahlungsrichtung der Beleuchtung weniger als 3°, insbesondere weniger als 1° von der Hauptstrahlungsrichtung der Referenzwelle ab bzw. ist insbesondere mit dieser deckungsgleich bzw. identisch. Hierdurch wird die optische Qualität der Leuchtfunktion und die Effizienz der holographischen Leuchtvorrichtung verbessert, weil Beleuchtung und holografische Struktur optimal aneinander angepasst sind.

In einer weiteren bevorzugten Ausführungsform der Erfindung ist die holografische Struktur eingerichtet für die Erzeugung der Leuchtfunktion des Kanals bei einer Beleuchtung mit einem Spektralbereich entsprechend der Lichtquelle des Kanals. Mit anderen Worten sind Spektralbereich von Kanal und holografischer Struktur vorzugsweise aufeinander abgestimmt. So kann vorzugsweise als ein Vorteil eine besonders effiziente Beleuchtung erzielt werden.

Insbesondere ist bevorzugt, dass zumindest zwei Kanäle eine Beleuchtung mit einem im Wesentlichen unterschiedlichen Spektralbereich aufweisen, wobei die holografische Struktur des Kanals eingerichtet ist für die Erzeugung der Leuchtfunktion nur bei einer Beleuchtung mit einem Spektralbereich entsprechend der Lichtquelle des Kanals. So kann eine bessere Trennung mindestens zwischen den zwei Kanälen erreicht werden. Oftmals sind verschiedene Spektralbereiche für die Leuchtfunktion zweier unterschiedlicher Kanäle vorgesehen, um bspw. verschiedenfarbige Anzeigen zu ermöglichen. Dies kann vorteilhafterweise ebenfalls zur Trennung der Kanäle verwendet werden. Insbesondere in Kombination mit einer Trennung der Kanäle gemäß der Beleuchtung entlang des azimutalen Anordnungswinkels und/oder einer Beleuchtung in einem Polarwinkel können synergistische Trenneffekte erzielt werden und die Trennung der Kanäle kann verbessert werden.

In einer weiteren bevorzugten Ausführungsform der Erfindung weist die Auskoppelfläche die holografische Struktur auf, wobei die holografische Struktur eine transmissive holografische Struktur ist, wobei Lichtquelle und Edge-Lit Anordnung eingerichtet sind für die Beleuchtung der Auskoppelfläche unter einem Winkel größer als ein kritischer Winkel der Totalreflektion.

Eine transmissive holografische Struktur umfasst insbesondere eine Struktur deren Leuchtfunktion bei der Betrachtung der holografischen Struktur von der einen Seite bei einer Beleuchtung von der anderen Seite realisiert wird bzw. die zur Erzeugung einer entsprechenden Leuchtfunktion eingerichtet ist. Insbesondere handelt es sich um eine zumindest teilweise lichtdurchlässige Struktur, deren holografische Funktion durch Beleuchtung mit Objektwelle und Referenzwelle von der gleichen Seite der Struktur erzeugt wurde. Eine transmissive holografische Struktur erzeugt insbesondere eine Leuchtfunktion, welche mit Blick auf die Auskoppelfläche festgestellt werden kann.

Es ist bevorzugt, dass die Auskoppelfläche bei üblicher Verwendung bzw. Anwendung der holographischen Leuchtvorrichtung an Luft unter Standardbedingungen angrenzt und sich entsprechend ein kritischer Winkel der Totalreflektion bei Kenntnis der Brechungsindizes, zum einen des monolithischen Bauteils umfassend die Auskoppelfläche und zum einen der angrenzenden Luft berechnen lässt. Der Fachmann weiß, wie sich der kritische Winkel berechnen lässt und kann die Vorrichtung entsprechend entwerfen. Insbesondere lässt sich der kritische Winkel anhand der Gleichung ϑ _{C} = arcsin(n₁/n₂) berechnen, wobei n₁ den Brechungsindex des optisch dichteren Mediums, hier z. B. PMMA und n₂ den Brechungsindex des optisch dünneren Mediums, hier z. B. Luft, bezeichnet.

Luft unter Standardbedingungen bezeichnet insbesondere Luft gemäß ISO 2533, vor allem Luft bei 288,15 Kelvin (K) bzw. 15° C, einem Luftdruck von 1013,25 Hektopascal (hPa) und einer relativen Luftfeuchtigkeit von 0 bzw. bei trockener Luft. Der Fachmann kann aber auch für Luft den üblichen Brechungsindex von etwa 1 annehmen und entsprechend den kritischen Winkel berechnen.

Es kann jedoch auch bevorzugt sein, dass die Auskoppelfläche an ein anderes Material als Luft angrenzt. Auch dann weiß der Fachmann anhand einer Änderung des Brechungsindizes an der Auskoppelfläche, wie der kritische Winkel der Totalreflektion berechnet werden muss.

Durch Beleuchtung der Auskoppelfläche unter einem Winkel größer als ein kritischer Winkel der Totalreflektion kann insbesondere eine Transmission bzw. eine Auskopplung der nullten Ordnung aus der Auskoppelfläche unterdrückt werden. Die nullte Ordnung ist vorteilhafterweise unerwünscht, da sie keine in der holografischen Struktur gespeicherten Informationen umfasst und eine potentielle Blendung des Betrachters verursachen kann.

Insbesondere sind Lichtquelle und Edge-Lit Anordnung eingerichtet für die Beleuchtung der Auskoppelfläche unter einem Winkel bevorzugt maximal um 30° größer als der Winkel der Totalreflektion, insbesondere um 10°größer. Bei einer Beleuchtung unter einem Winkel größer als der kritische Winkel kann wie vorstehend beschrieben vorteilhafterweise die nullte Ordnung an der Auskopplung durch die Auskoppelfläche gehindert werden. Gleichzeitig ist jedoch eine Beleuchtung der holografischen Struktur unter einem zu großen Winkel bevorzugt nachteilig, da die optische Qualität von Hologrammen dabei häufig leidet.

Des Weiteren muss bei einer "zu seitlichen Beleuchtung", d. h. bevorzugt unter (zu) großen Winkeln, die laterale Ausdehnung des monolithischen Bauteils unvorteilhaft groß gewählt werden, damit die schräge Beleuchtung der bevorzugt kompletten Auskoppelfläche ansonsten schwer durch die Reflektionsflächen realisieren lässt.

In einer weiteren bevorzugten Ausführungsform der Erfindung weist eine zur Auskoppelfläche parallele Fläche die holografische Struktur auf, wobei die holografische Struktur eine reflektive holografische Struktur ist.

Dabei kann bevorzugt entweder eine Beleuchtung so erfolgen, dass das Beleuchtungslicht direkt von der Reflektionsfläche, entsprechend der beanspruchten Erfindung, erfolgt oder aber, in einer nicht beanspruchten Ausführungsform, das Beleuchtungslicht zunächst unter einem Winkel größer als der Grenzwinkel der Totalreflektion auf die Auskoppelfläche trifft und von dort zur reflektiven holographischen Struktur reflektiert wird

Bei der Verwendung einer reflektiven holografischen Struktur kann insbesondere eine spektrale Selektion der holografischen Struktur verbessert werden, so dass die holografische Struktur die Leuchtfunktion bspw. nur in einem engen Spektralbereich erzeugt. So kann eine bessere Trennung der Kanäle erreicht werden, wenn die Lichtquellen der verschiedenen Kanäle unterschiedliche Spektren aufweisen und/oder die Bedingungen an die spektralen Eigenschaften der Lichtquelle können bei gleichbleibender optischer Qualität der Leuchtfunktion gelockert werden.

Insbesondere sind Lichtquelle und Edge-Lit Anordnung eingerichtet für die Beleuchtung der zur Auskoppelfläche parallelen holografischen Struktur. Damit nicht die Auskoppelfläche, sondern die zur Auskoppelfläche parallele holografische Struktur angeleuchtet wird, kann der Strahlengang so entsprechend angepasst werden. Bezüglich der Edge-Lit Anordnung betrifft dies insbesondere die Einkoppelfläche und/oder die Reflektionsfläche.

Bevorzugt sind Lichtquelle und Edge-Lit Anordnung eingerichtet für die Beleuchtung der zur Auskoppelfläche parallelen holografischen Struktur unter einem Polarwinkel größer als der kritische Winkel der Totalreflektion. Da somit vorteilhafterweise die nullte Ordnung innerhalb des Bauteils reflektiert wird, z. B. an einer der Auskoppelfläche gegenüberliegende Grenzfläche, und im Bauteil verbleibt, kann die nullte Ordnung durch diese Ausführungsform vorteilhafterweise unterdrückt werden. Durch Reflektion an einer der Auskoppelfläche gegenüberliegende Grenzfläche kann vorteilhafterweise sichergestellt werden, dass die nullte Ordnung auch an der Auskoppelfläche reflektiert wird, da die beiden Flächen bevorzugt im Wesentlichen parallel sind. Es kann ebenso bevorzugt sein, dass Lichtquelle und Edge-Lit Anordnung eingerichtet sind für die Beleuchtung der zur Auskoppelfläche parallelen holografischen Struktur unter einem Polarwinkel kleiner als der kritische Winkel der Totalreflektion. Damit kann vorteilhafterweise die nullte Ordnung an einer der Auskoppelfläche gegenüberliegenden Grenzfläche ausgekoppelt werden und stört nicht das durch die holografische Struktur in Richtung der Auskoppelfläche gebeugtes Licht zur Erzeugung der Leuchtfunktion.

In einer weiteren bevorzugten Ausführungsform der Erfindung sind die Reflektionsflächen so angeordnet, dass sie mindestens eine seitliche Außenfläche des monolithischen Bauteils zumindest teilweise bilden. Seitlich bzw. lateral bezeichnet bevorzugt einen äußeren Bereich/eine äußere Grenzfläche (vulgo "Außenfläche") der holographischen Leuchtvorrichtung bzw. des monolithischen Bauteils, welche sich nicht "unten" oder "oben" befinden (s. bevorzugt vorstehende Definitionen), wobei "oben" oder "Oberseite" vorzugsweise eine "unten" oder "Unterseite" im Wesentlichen gegenüberliegende Grenzfläche bzw. einen im Wesentlichen gegenüberliegenden Bereich der holographischen Leuchtvorrichtung bzw. des monolithischen Bauteils bezeichnet. Werden die Reflektionsflächen auf diese Art in die seitliche Außenfläche "integriert", entsteht eine "Doppelfunktion" dieser seitlichen Außenfläche, einmal als Grenzfläche, einmal als Reflektionsfläche. Somit kann die Vorrichtung besonders kompakt und einfach gestaltet werden. Es kann vorteilhafterweise das Volumen des monolithischen Bauteils optimal für die Strahlengänge des eingekoppelten Lichts genutzt werden. Die Strahlengänge können mithin für eine verbesserte Leuchtfunktion bei gleichzeitig kompakter Bauweise optimiert werden. In einer weiteren bevorzugten Ausführungsform sind die Einkoppelflächen in Richtung eines Inneren des monolithischen Bauteils angeordnet, wobei sie so angeordnet sind, dass sie einen teilweise offenen Innenbereich des monolithischen Bauteils zumindest bereichsweise seitlich umschließen. Bevorzugt befinden sich die Einkoppelflächen oben. Das eingekoppelte Licht gelangt von diesen über eine Reflektion an den Reflektionsflächen zur Auskoppelfläche bzw. zur holografischen Struktur. Dabei können die Einkoppelflächen bevorzugt zum Inneren des monolithischen Bauteils angeordnet sein, was insbesondere bedeutet, dass sie zumindest teilweise in eine Gegenrichtung, zu der ihnen am nächsten liegenden seitlichen Außenfläche orientiert angeordnet sind. Die Einkoppelflächen sind dabei vorzugsweise Grenzflächen, die einen Übergang von der Edge-Lit Anordnung zu einem Äußeren darstellen, welcher nach innen zeigt. Insbesondere weisen sie eine außerhalb der Anordnung liegende Flächennormale auf, die ins Innere der Vorrichtung bzw. in Richtung der Flächennormalen der Auskoppelfläche zeigt. Dabei müssen sie keine vollständige Vertikale Orientierung aufweisen, sondern können eine Orientierung in einem Winkel zur Vertikale aufweisen. Die Flächennormale kann ebenso eine Flächennormale in einer Tangentialebene der Einkoppelfläche sein, wenn die Einkoppelfläche keine gerade Ebene umfasst, sondern gekrümmt ist. Dabei liegt die Tangentialebene insbesondere in einem geometrischen Schwerpunkt der Einkoppelfläche vor. Durch eine solche Anordnung der Einkoppelfläche ist eine Anordnung der der Einkoppelfläche zugeordneten Lichtquelle möglich, welche nicht außerhalb einer lateralen Ausdehnung der holographischen Leuchtvorrichtung angeordnet vorliegt, sondern innerhalb. So kann insbesondere in lateraler Richtung Bauraum gespart werden.

Vorzugsweise sind die Einkoppelflächen so angeordnet, dass sie einen teilweise offenen Innenbereich des monolithischen Bauteils zumindest bereichsweise seitlich umschließen. Hierdurch wird ein nach oben offener Innenbereich des monolithischen Bauteils zumindest an den Seiten gebildet, an denen eine Edge-Lit Anordnung samt Einkoppelfläche vorliegt.

Nach unten kann dieser Innenbereich vorzugsweise durch eine Grenzfläche umschlossen sein, auf der die holografische Struktur vorliegt, insofern sie nicht auf der Auskoppelfläche vorliegt.

In einer weiteren bevorzugten Ausführungsform der Erfindung sind die Reflektionsflächen so angeordnet, dass sie mindestens eine seitliche Außenfläche des monolithischen Bauteils zumindest teilweise bilden und die Einkoppelflächen sind in Richtung eines Inneren des monolithischen Bauteils angeordnet, wobei sie so angeordnet sind, dass sie einen teilweise offenen Innenbereich des monolithischen Bauteils zumindest bereichsweise seitlich umschließen. Diese Ausführungsform lässt einen besonderes vorteilhaften Strahlverlauf zu, welcher eine gute Ausleuchtung der Auskoppelfläche bei gleichzeitig kompaktem Aufbau ermöglicht. Dabei kann durch eine gegenüber der Einkoppelfläche angeordnete Lichtquelle Licht in die Anordnung eingekoppelt werden, welches in Richtung der seitlichen Außenfläche orientiert ist und durch die von der seitlichen Außenfläche umfassten Reflektionsfläche reflektiert wird. Dabei ist vorzugsweise die Reflektionsfläche so gegenüber einer vertikalen Richtung verkippt, dass das reflektierte Licht auf die untere Auskoppelfläche bzw. auf die holografische Struktur gerichtet wird. So können bei einem insgesamt kompakten Aufbau der Vorrichtung vorteilhafterweise relativ lange Strahlenwege realisiert werden, da der Strahl innerhalb der Vorrichtung durch die Reflektionsfläche abgelenkt wird und der Bauraum dabei optimal genutzt wird.

Es ist insbesondere bevorzugt, dass es einen ersten und einen zweiten konzentrischen Kreis um die Flächennormale der Auskoppelfläche gibt, wobei die Einkoppelflächen vom ersten Kreis in einem einzigen Punkt berührt werden und die Reflektionsflächen vom zweiten Kreis in einem einzigen Punkt berührt werden, wobei insbesondere der zweite Kreis einen größeren Radius auf als der erste Kreis aufweist. Die zwei Kreise müssen nicht unbedingt in der gleichen Ebene liegen, jedoch zumindest in Parallelebenen zueinander, welche senkrecht zur Flächennormalen der Auskoppelfläche sind. Dabei stellt eine solche Anordnung eine besonders vorteilhafte Realisierung der vorstehend genannten Ausführungsform dar, welche besonders kompakt und symmetrisch ist, wodurch sich unter anderem Vorteile bei der Fertigung ergeben.

Bevorzugt weist die Reflektionsfläche einen Winkel von weniger als 20° mit der vertikalen Richtung auf. Es kann bevorzugt sein, dass die Reflektionsfläche keine ebene Fläche aufweist. Dann weist die Reflektionsfläche vorzugsweise eine Tangentialebene auf, insbesondere durch deren geometrischen Schwerpunkt, die einen Winkel von weniger als 20° mit der vertikalen Richtung aufweisen. So kann insbesondere in Kombination mit der Ausführungsform, dass die Lichtquelle oberhalb einer zur Flächennormalen der Auskoppelfläche senkrechten Anordnungsebene der Einkoppelflächen angeordnet und eingerichtet ist für eine Einstrahlung in die ihr zugeordnete Einkoppelfläche in einem Winkel zur Anordnungsebene der Einkoppelflächen ein Abstand zwischen Einkoppelfläche und Reflektionsfläche gering gehalten werden, ohne Strahlen innerhalb des Bauteils abzuschneiden.

Bevorzugt weisen in mindestens einer zur Flächennormalen der Auskoppelfläche orthogonalen Schnittebene jede Einkoppelfläche entlang des dem Kanal zugeordneten Winkels einen ersten Abstand zur Flächennormalen auf und die Reflektionsflächen weisen einen zweiten Abstand zur senkrechten Achse auf. Vorzugsweise ist der erste Abstand kleiner als der zweite Abstand. So kann eine besonders gut an einen vorgegebenen Bauraum angepasste und strahloptimierte Vorrichtung bereitgestellt werden.

In einer weiteren bevorzugten Ausführungsform der Erfindung liegen die Elemente und Komponenten jeweils entlang einer zur Flächennormalen senkrechten Anordnungsebene der jeweiligen Elemente oder Komponenten angeordnet vor. Von den Elementen sind insbesondere umfasst: die Einkoppelfläche, die Auskoppelfläche, die holografische Struktur und/oder die Reflektionsfläche. Von den Komponenten sind vorteilhafterweise die Lichtquellen und die Edge-Lit Anordnung umfasst. Insbesondere ist folgende Anordnung vorteilhaft entlang einer Richtung der Flächennormalen: zuerst die Anordnungsebene der Auskoppelfläche mit der holografischen Struktur, dann die Anordnungsebene der Reflektionsfläche, darauffolgend die Anordnungsebene der Einkoppelfläche.

Es kann ebenso folgende Anordnung vorteilhaft sein (von unten nach oben): zuerst die Anordnungsebene der Auskoppelfläche, dann die Anordnungsebene der Reflektionsfläche und der holografischen Struktur, darauffolgend die Anordnungsebene der Einkoppelfläche.

Die Lichtquelle kann vorzugsweise in der Ebene der Einkoppelfläche oder oberhalb dieser Ebene angeordnet vorliegen. Die Anordnungsebene der jeweiligen Elemente oder Komponenten schneidet oder berührt dabei vorzugsweise die Elemente oder Komponenten.

Es ist bevorzugt, dass die Kanäle drei Strukturebenen aufweisen, welche senkrecht zur Flächennormalen der Auskoppelfläche verlaufen:
- eine erste Strukturebene, welche die Auskoppelfläche umfasst oder berührt,
- eine zweite Strukturebene, welche eine Schnittfläche der Einkoppelflächen und der Reflektionsflächen umfasst,
- eine dritte Strukturebene, welche eine Anordnungsebene der Lichtquellen umfasst.

In einer weiteren bevorzugten Ausführungsform der Erfindung weisen die Edge-Lit-Anordnungen der Kanäle einen Aufbau mit im Wesentlichen einheitlichen Abmessungen auf. Das bedeutet vorzugsweise, dass die einzelnen, im monolithischen Bauteil umfassten Edge-Lit Anordnungen jeweils gleiche Abmessungen aufweisen. Diese Abmessungen beziehen sich insbesondere auf die äußeren Grenzflächen der Edge-Lit Anordnungen welche mithin bevorzugt die äußeren Grenzflächen des monolithischen Bauteils im Wesentlichen bilden. Es kann sich jedoch zusätzlich zu den äußeren Grenzflächen zusätzlich um einheitliche Abmessungen bezüglich der Grenzflächen der Edge-Lit Anordnungen innerhalb des Bauteils handeln, welche durch Verwendung des monolithischen Bauteils vielmehr lediglich "gedacht" sind bzw. bei der Konstruktion eine Rolle spielen. Im Wesentlichen einheitliche Abmessungen umfassen vorteilhafterweise leichte Asymmetrien, welche aus optischen Gründen eingeführt werden (s. u.). Durch einen solchen Aufbau können die Entwicklungs- und Herstellungskosten verringert werden.

In einer weiteren bevorzugten Ausführungsform der Erfindung sind die Kanäle überwiegend rotationssymmetrisch um die Flächennormale zur Auskoppelfläche angeordnet, wobei bevorzugt zwei Kanäle umfasst sind, die eine gegenüberliegende Anordnung in Bezug auf die Flächennormale aufweisen, wobei ein Winkel zwischen den Anordnungswinkeln der Kanäle 180° beträgt oder wobei bevorzugt vier Kanäle umfasst sind, wobei der Winkel zwischen den Anordnungswinkeln der Kanälen 90° beträgt.

Eine überwiegend rotationssymmetrische Anordnung umfasst insbesondere eine Anordnung, welche durch Rotation um die Flächennormale in einem bestimmten Winkel im Wesentlichen in sich selbst überführt werden kann. Leichte Abweichungen wie gewünschte Asymmetrien aus optischen Gründen (s. u.) bzw. Abweichungen in der Lichtquelle (z. B. Frequenzspektrum oder Helligkeit sind vorzugsweise von der überwiegend rotationssymmetrischen Anordnung umfasst. Eine solche Anordnung ist besonders günstig im Design und kann sehr gut einer Massenproduktion zugeführt werden.

In einer bevorzugten Ausführungsform der Erfindung sind zwei bis fünf Kanäle umfasst, insbesondere zwei bis vier Kanäle umfasst. Es sind insbesondere genau 4 Kanäle umfasst. Dadurch kann ein guter Kompromiss zwischen Einfachheit der Herstellung und Variabilität der zu erzeugenden Leuchtfunktionen erreicht werden.

In einer weiteren bevorzugten Ausführungsform der Erfindung weisen zwei Kanäle zueinander eine azimutale Abweichung von einer gegenüberliegenden Anordnung in Bezug auf die Flächennormale der Auskoppelfläche auf, vorzugsweise um mindestens 1°. So kann eine versehentliche Einkopplung in den anderen Kanal verhindert bzw. im Wesentlichen verhindert werden.

Es kann dabei besonders bevorzugt sein, dass die Abweichung größer ist als ein Toleranzwinkelbereich der holografischen Struktur um den azimutalen Anordnungswinkel herum. So kann erreicht werden, dass bei überwiegend gegenüberliegenden Anordnungen keine Beleuchtung entlang des azimutalen Anordnungswinkels aus den beiden Anordnungen stattfindet und die Kanäle besser getrennt werden können.

Ebenso kann dadurch unabhängig von einem Toleranzwinkelbereich verhindert werden, dass ein von der Auskoppelfläche reflektierter Strahl (z. B. die nullte Ordnung) eines Kanals an der Lichtquelle des anderen Kanals reflektiert wird und von dort in dessen Einkoppelfläche eingekoppelt wird und somit unerwünschterweise in den anderen Kanal gelangt.

Bei einer komplett symmetrischen Anordnung kann das Licht einer Lichtquelle, welches einmal durch das Bauteil gelaufen ist, wieder auf eine Lichtquelle eines anderen Kanals treffen (das wäre bevorzugt die 0.te Beugungsordnung, während die 1.te ausgekoppelt wird). Dabei kann im worst case durch Reflexion an der Lichtquelle wieder in das Bauteil eingekoppelt werden und/oder eine ausgeschaltete LED angeregt werden, so dass die Leuchtfunktion eines ausgeschalteten Kanals erzeugt würde.

In einer weiterhin vorteilhaften Ausgestaltung sind die Kanäle leicht asymmetrisch aufgebaut, sodass sich dadurch die Rekonstruktionswinkel der holografischen Strukturen unterscheiden können. Zusätzlich kann dadurch verhindert werden, dass Licht, welches z.B. von einer Lichtquelle über Reflexion innerhalb des Optikteils durch die Einkoppelfläche wieder ausgekoppelt wird, auf die andere Lichtquelle trifft (analog für den anderen Kanal).

In einer weiteren bevorzugten Ausführungsform der Erfindung weisen zwei Kanäle, bevorzugt zwei gegenüberliegende Kanäle, zueinander eine Abweichung eines Betrages des Vertikalwinkels (Polarwinkels) auf, vorzugsweise zwischen 1° und 10°. So kann vorteilhafterweise ebenfalls verhindert werden, dass Licht des einen Kanals durch Reflektion in den anderen Kanal gelangen und dort eine Leuchtfunktion anregen kann.

Der Betrag der Polarwinkel beider Kanäle ist vorzugsweise gleich, wenn diese z. B. gegenüberliegen und der eine Winkel Θ₁ und der andere Winkel Θ₂ beträgt, wobei Θ₁ = - Θ₂. Eine kleine Abweichung von dem grundsätzlichen bevorzugten, symmetrischen Aufbau kann dabei eine bessere Trennung der Kanäle bewirken.

Ein solche Asymmetrie würde bspw. bewirken, dass die Auskoppelfläche bzw. die holografische Struktur für jeden Kanal unter unterschiedlichen Winkeln beleuchtet wird. Dazu müssen Lichtquelle, Einkoppel- und Reflexionsfläche vorteilhafterweise im Vergleich in einem etwas anderen Winkel zueinander stehen. Somit würden zum einen vorteilhafterweise sowohl unerwünschte Reflektionen in den falschen Kanal verhindert als auch ein Freiheitsgrad geschaffen, die Hologramme in jedem Kanal unter einem leicht anderen Winkel zu rekonstruieren.

Um die kompakte Bauform zu erhalten, ist es jedoch vorteilhaft, wenn die Abweichung nicht zu groß ist. Durch zu starke Variation würden ebenfalls die benötigten Strahlquerschnitte zur Ausleuchtung der Auskoppelfläche bzw. der holografischen Struktur zu unterschiedlich bezüglich ihrer Anforderungen an den Bauraum. Bevorzugt beträgt daher ein Unterschied im Betrag des Polarwinkels max. 10°.

In einer bevorzugten Ausführungsform der Erfindung umfasst die Lichtquelle mindestens eine LED, insbesondere genau eine LED. LEDs sind besonders einfach, langlebig und kostengünstig und weisen bezüglich einer Vielzahl von Leuchtfunktionen, insbesondere holographischer Leuchtfunktionen, ausreichende optische Eigenschaften, insbesondere bezüglich ihrer Kohärenz auf. LEDs sind besonders effizient.

Bevorzugt weisen LED-Emitter Abmessungen zwischen 0,5 x 0,5 mm² und 1 x 1 mm² auf. Allgemein kann man sagen, dass für unsere Anwendung kleinere Emitterflächen immer vorteilhaft sind. Der Mindestabstand der Einkoppelfläche ist dabei unabhängig von der Emittergröße (im Gegensatz zum Mindestabstand der Reflexionsfläche).

In einer bevorzugten Ausführungsform der Erfindung emittieren die LEDs verschiedener Kanäle in einem gemeinsamen Spektralbereich. So können unterschiedliche Leuchtfunktion erzeugt werden, welche einen gemeinsamen Spektralbereich aufweisen, insbesondere im Wesentlichen gleichfarbige Anzeigefunktionen.

In einer weiteren bevorzugten Ausführungsform der Erfindung emittieren die LEDs verschiedener Kanäle in einem unterschiedlichen Spektralbereich. So können besonders vorteilhafte, verschiedenfarbige Leuchtfunktionen realisiert werden, insbesondere Anzeigen mit verschiedenfarbigen unterschiedlichen Warnstufen.

In einer weiteren bevorzugten Ausführungsform der Erfindung kann das Emissionsspektrum der LED einer Farbe zugeordnet werden. Das bedeutet insbesondere, die der LED (deren Kanal) zugeordnete Leuchtfunktion ist einfarbig.

In einer weiteren bevorzugten Ausführungsform der Erfindung kann das Emissionsspektrum der LED nicht einer Farbe zugeordnet werden, sondern umfasst ein mehrfarbiges Spektrum. So kann für einen Kanal eine mehrfarbige Leuchtfunktion erreicht werden, z. B. eine weiße Anzeige. Insbesondere handelt es sich dabei um eine RGB-LED (RGB = Red/Green/Blue), welche einen oder mehrere Emitter für R, G und B aufweist, welche bevorzugt (bei mehreren Emittern) einzeln angesteuert werden können.

Es kann sich beispielsweise um eine Osram MULTILED LRTB GVSG handeln, welche bei 625 nm (rot), 528 nm (true grün), 460 nm (blau) emittiert. Intensitäten können bspw. 500 - 1000 Milli-Candela (mcd) für rot, 1250 - 2010 mcd für grün und 180 - 560 mcd für blau betragen.

In der Erfindung sind die Lichtquelle, die Einkoppelfläche und/oder die Reflektionsfläche eingerichtet für eine Beleuchtung der holografischen Struktur mit definieren Lichtstrahlen der Lichtquelle, welche angepasst sind an eine Referenzwelle, mit der die holografische Struktur aufgenommen wurde. Definierte Lichtstrahlen bezeichnet vorzugsweise ebensolche Lichtstrahlen, welche angepasst sind an die Referenzwelle bezüglich ihrer Eigenschaften. Ihre Eigenschaften sind insbesondere ausgesucht aus der Gruppe umfassend: Kohärenz (räumlich und/oder zeitlich), Richtung, Hauptstrahlungsrichtung, Winkelspektrum und/oder Frequenzspektrum. Ein Fachmann weiß, wie er dies erreichen kann. Eine Anpassung kann insbesondere darin bestehen, dass die Lichtstrahlen im Wesentlichen gleiche Eigenschaften aufweisen wie die Referenzlichtquelle. So kann eine Leuchtfunktion mit besonders hoher Qualität erzielt werden, z. B. ein Hologramm mit einer besonders hohen (Tiefen-) Schärfe.

Vorzugsweise ist der Begriff Hauptstrahlungsrichtung synonym mit dem Begriff Hauptstrahlrichtung.

In einer weiteren bevorzugten Ausführungsform der Erfindung ist die Reflektionsfläche eingerichtet für eine Beleuchtung der holografischen Struktur mit definierten Lichtstrahlen, wobei die Reflektionsfläche bevorzugt freigeformt oder plan ist. Durch eine entsprechend ausgeführte Reflektionsfläche kann insbesondere die Hauptstrahlrichtung und/oder das Winkelspektrum entsprechend an die Referenzwelle angepasst werden.

In einer weiteren bevorzugten Ausführungsform der Erfindung sind die Lichtquelle, die Einkoppelfläche und/oder die Reflektionsfläche eingerichtet für eine homogene Beleuchtung der holografischen Struktur. Homogen bedeutet dabei insbesondere, dass die holografische Struktur in ihrer gesamten Fläche mit der überwiegend gleichen Intensität ausgeleuchtet wird. Bevorzugt beträgt eine Abweichung der Intensität über die holografische Struktur, insbesondere im Wesentlichen die gesamte holografische Struktur, weniger als 20%, stärker bevorzugt weniger als 10% und insbesondere weniger als 5%. Vorzugsweise beträgt ein Verhältnis von minimaler Intensität Iₘᵢₙ (bzw. minimaler Beleuchtungs- oder Bestrahlungsstärke) zu maximaler Intensität Iₘₐₓ (bzw. maximaler Beleuchtungs- oder Bestrahlungsstärke) Iₘᵢₙ/Iₘₐₓ > 0,8.

In einer weiteren bevorzugten Ausführungsform der Erfindung sind die Lichtquelle, die Einkoppelfläche und/oder die Reflektionsfläche eingerichtet für eine inhomogenen Beleuchtung der holografischen Struktur, bevorzug mit einem Intensitätsabfall zu einem Randbereich und/oder einem Mittelbereich der holografischen Struktur hin.

Intensitätsverläufe innerhalb bzw. durch die holografische Struktur können zum einen durch eine Variation der Effizienz der holografischen Struktur gesteuert werden. So kann bspw. von 100% (alles Licht wird ausgekoppelt) bis 50% (die Hälfte des Lichts wird ausgekoppelt) variiert werden.

Hierbei "wird" jedoch ein Teil des Lichtes, welches die holografische Struktur ausleuchtet, nicht genutzt, da es nicht ausgekoppelt wird. Zum anderen können Lichtquelle, Einkoppelfläche und insbesondere Reflektionsfläche eingerichtet sein für eine Ausleuchtung der holografischen Struktur mit einem Intensitätsverlauf. Z. B. wird die holografische Struktur durch geeignete Form der Reflektionsfläche bereits inhomogen beleuchtet (z. B. von 100% bis 50% Intensität). Dann weist die holografische Struktur vorzugsweise überall eine Effizienz von 100% auf, d.h. alles Licht wird ausgekoppelt (wenn man bspw. die 0. Ordnung außer Acht lässt). So kann durch diese Ausführungsform, welche auf die Beleuchtung mit einem Intensitätsverlauf ausgerichtet ist, ein definierter Intensitätsverlauf gefordert werden und gleichzeitig die Menge an ausgekoppeltem Licht bzw. die Effizienz maximiert werden. Gleichzeitig können so besondere Leuchtfunktionen erzeugt werden.

In einer bevorzugten Ausführungsform ist die holografische Struktur eingerichtet zur Erzeugung einer holografischen Leuchtfunktion, welche einen Intensitätsverlauf aufweist. Insbesondere in Kombination mit einer inhomogenen Beleuchtung gemäß der vorgenannten Ausführungsform können verbesserte Leuchtfunktionen bereitgestellt werden.

In einer weiteren bevorzugten Ausführungsform der Erfindung sind Lichtquellen, funktionale und/oder nicht-funktionale Außenflächen des Bauteils eingerichtet/angeordnet für eine überwiegende Beleuchtung der Auskoppelfläche und/oder der holografischen Struktur ohne eine vorhergehende Reflektion und/oder ein Abschneiden eingekoppelter Lichtstrahlen durch nicht-funktionale Außenflächen des Bauteils. Dabei gilt eine Reflektion an der Reflektionsfläche insbesondere nicht als Reflektion an einer nicht-funktionalen Außenfläche, da es sich ja bei der Reflektionsfläche um eine funktionale Außenfläche handelt. Das bedeutet insbesondere, dass die Außenfläche so zueinander angeordnet und beabstandet sein müssen, dass ein gesamtes Strahlbündel eines Kanals im Wesentlichen ungehindert entlang eines beabsichtigen Strahlengangs bis zur Auskoppelfläche und/oder holografischen Struktur geführt wird. Dabei sind insbesondere Lichtquelle, Einkoppelfläche, Reflektionsfläche, holografische Struktur und Auskoppelfläche entsprechend zueinander angeordnet und/oder weisen entsprechende Winkel zu einer Vertikalen/zueinander auf.

Als Beispiel kann ein Mindestabstand zwischen Lichtquelle und Einkoppelfläche betrachtet werden, welcher gewählt ist, um das eingekoppelte Winkelspektrum des Lichts und somit ungewollte Reflektionen im Bauteil zu reduzieren

Ein solcher Mindestabstand hängt zum einen ab von der Größe der ausgeleuchteten Auskoppelfläche und/oder holografischen Struktur und der damit verbundenen Größe der Reflexionsfläche, sowie von der absoluten Position der Reflexionsfläche. Die Einkoppelfläche sollte dann so weit wie möglich von der LED entfernt sein, sodass potentielles Störlicht nicht in das Bauteil eingekoppelt wird. Es kann sich bspw. ergeben, dass bei einem Abstand der Lichtquelle und der zugeordneten Reflektionsfläche von mindestens 20 mm sich ein Mindestabstand von 8 mm zwischen Lichtquelle und Einkoppelfläche ergibt. Gleichzeitig sollte ein bevorzugt kollimiertes, reflektiertes Lichtbündel nicht durch Bauteilkanten beschnitten werden.

In einer weiteren bevorzugten Ausführungsform der Erfindung beträgt der Abstand zwischen Lichtquelle und der ihr zugeordneten Einkoppelfläche mindestens 8 mm. So können insbesondere unerwünschte Reflektionen aufgrund eines zu großen eingekoppelten Winkelspektrums der Lichtquelle verhindert werden, wobei die Lichtquelle vorzugsweise als Punktlichtquelle angenähert wird.

In einer weiteren, nicht beanspruchten Ausführungsform liegt die Lichtquelle auf einer gleichen Seite der Flächennormalen der Auskoppelfläche wie die ihr zugeordnete Einkoppelfläche angeordnet vor, bevorzugt in dem Innenbereich des monolithischen Bauteils. Diese Ausführungsform ist besonders bevorzugt, wenn die Lichtquellen in einem Innenbereich des Bauteils untergebracht werden. Dadurch kann die Bauhöhe der gesamten Vorrichtung verringert werden. Der Abstand zwischen Lichtquelle und Einkoppelfläche ist bevorzugt dadurch limitiert, dass ein maximaler Abstand durch den Abstand zwischen Einkoppelfläche und Flächennormale der Auskoppelfläche gegeben ist.

Es ist insbesondere bevorzugt, dass es einen konzentrischen Kreis um die Flächennormale der Auskoppelfläche, bevorzugt einen dritten konzentrischen Kreis gibt, auf dem die Lichtquellen im Wesentlichen angeordnet vorliegen. Der Radius des dritten Kreises ist vorzugsweise kleiner als der Radius des ersten Kreises und des zweiten Kreises. Die drei Kreise müssen nicht unbedingt in der gleichen Ebene liegen, jedoch zumindest in Parallelebenen zueinander, welche senkrecht zur Flächennormalen der Auskoppelfläche sind.

In einer weiteren bevorzugten Ausführungsform der Erfindung überkreuzen sich die Lichtstrahlen der Lichtquellen zweier gegenüberliegender Kanäle vor der Einkopplung des Lichtes in die jeweilige Einkoppelfläche.

Überkreuzen bedeutet dabei bevorzugt, dass die Lichtstrahlen vorzugsweise zumindest entlang einer Ebene entgegengesetzte Richtungen aufweisen und sich dabei insbesondere in einer Schnittebene senkrecht zu dieser Ebene unter einem Winkel schneiden. Diese entgegengesetzten Richtungen in zumindest einer Ebene können insbesondere Projektionen der tatsächlichen Richtungen in dieser Ebene sein, wobei der Schnittwinkel in der Schnittebene insbesondere ungleich 0° bzw. 180° ist.

In der beanspruchten Erfindung liegt die Lichtquelle auf einer gegenüberliegenden Seite der Flächennormalen der Auskoppelfläche wie die ihr zugeordnete Einkoppelfläche angeordnet vor, vorzugsweise außerhalb des Innenbereichs des monolithischen Bauteils, insbesondere entlang eines Randbereichs der seitlichen Außenfläche des monolithischen Bauteils. Durch eine der jeweiligen Einkoppelfläche zugeordneten Lichtquelle, welche auf einer gegenüberliegenden Seite der Einkoppelfläche liegt, kann die optische Qualität verbessert werden, indem ein Abstand zwischen Lichtquelle und Einkoppelfläche und zwischen Lichtquelle und Reflektionsfläche erhöht wird. Insbesondere kann eine Lichtquelle gesehen von der Einkoppelfläche und/oder der Reflektionsfläche aus auf diese Art als Punktlichtquelle angenähert werden, wodurch eine bevorzugte Kollimation des Lichtes der Lichtquelle durch Einkoppelfläche und/oder Auskoppelfläche verbessert werden kann. Des Weiteren ist das Winkelspektrum des in die Einkoppelfläche eingekoppelten Lichtes vorzugsweise durch den großen Abstand verringert und eine saubere Strahlführung ohne unerwünschte Reflektionen im Bauteil wird verbessert.

Es ist insbesondere bevorzugt, dass es einen konzentrischen Kreis um die Flächennormale der Auskoppelfläche, bevorzugt einen vierten konzentrischen Kreis gibt, auf dem die Lichtquellen im Wesentlichen angeordnet vorliegen. Der Radius des vierten Kreises ist vorzugsweise größer als der Radius des ersten Kreises. Der Radius des vierten Kreises ist insbesondere ähnlich zum Radius des zweiten Kreises. Ähnlich bedeutet in diesem Zusammenhang vorzugsweise, dass eine Abweichung kleiner 10% ist. Der Radius des vierten Kreises kann auch im Wesentlichen dem Radius des zweiten Kreises entsprechen. Bei dieser Ausführungsform werden die Lichtquellen mehrerer Kanäle nicht in einer Nachbarschaft zueinander um die Flächennormale der Auskoppelfläche herum angeordnet (bzw. im Innenbereich), sondern in einem äußeren Bereich mit einem vorteilhafterweise größerem Abstand zueinander. So können auch eine Vielzahl von Lichtquellen für eine Vielzahl von Kanälen untergebracht werden, ohne dass sie sich gegenseitig räumlich behindern. Auch eine Kühlung der einzelnen Lichtquellen ist somit besser möglich, da sie weiter voneinander beabstandet und somit besser belüftet werden können, ohne sich gegenseitig zu erwärmen. Auch für elektrische Verbindungen der Lichtquellen mit einer Steuerung und/oder einer elektrischen Energieversorgung ist mithin besser möglich, da der Raumbedarf nicht so sehr durch benachbarte Lichtquellen verengt wird.

In einer bevorzugten Ausführungsform der Erfindung sind die Lichtquellen (bevorzugt in einer Parallelebene zu einer Anordnungsebene der Einkoppelflächen) derart angeordnet, dass ein Abstand zu den zugeordneten Einkoppelflächen maximiert wird, ohne die Abmessungen der holografischen Anzeige in eine Richtung senkrecht zur Anzeigenachse zu erhöhen. Das bedeutet insbesondere, dass die Lichtquellen entlang eines seitlich Randbereiches des Bauteils angeordnet vorliegen, ohne in lateraler Richtung über die durch den seitlichen Randbereich vorgegebenen Abmessungen hinauszuragen. Der seitliche Randbereich des Bauteils kann dabei vorzugsweise zumindest teilweise durch die Reflektionsflächen gebildet werden und bezeichnet bevorzugt die seitliche Außenfläche des monolithischen Bauteils. Insbesondere sind die Lichtquellen entlang eines Randbereichs der seitlichen Außenfläche angeordnet. Der Randbereich der seitlichen Außenfläche bezeichnet vorzugsweise deren Oberkante bzw. die gemeinsame Kante mit einer Verbindungsfläche zwischen Einkoppelfläche und Auskoppelfläche. Eine Variante dieser Ausführungsform ist bevorzugt die vorstehend beschriebene Anordnung der Lichtquellen entlang des vierten konzentrischen Kreises.

In einer weiteren bevorzugten Ausführungsform der Erfindung ist die Lichtquelle oberhalb einer zur Flächennormalen der Auskoppelfläche senkrechten Anordnungsebene der Einkoppelflächen angeordnet und ist bevorzugt eingerichtet für eine Einstrahlung in die ihr zugeordnete Einkoppelfläche in einem Winkel zur Anordnungsebene der Einkoppelflächen. Der Winkel ist bevorzugt so gewählt, dass die Hauptstrahlungsrichtung der Lichtquelle im Verhältnis zu der ihr zugeordneten Einkoppelfläche optimiert wird. Die Anordnungsebene der Einkoppelfläche ist vorzugsweise synonym mit der zweiten Strukturebene.

Bei dieser Ausführungsform kann der Abstand zwischen Lichtquelle und der ihr zugeordneten Einkoppelfläche und/oder der ihr zugeordneten Reflektionsfläche bevorzugt groß gewählt werden, ohne den benötigten Bauraum der Vorrichtung stark zu erhöhen. Insbesondere die laterale Ausdehnung der Vorrichtung wird hierdurch im Wesentlichen nicht geändert. Lediglich in vertikale Richtung wird der Platzbedarf etwas erhöht, da die Lichtquellen oberhalb der Anordnungsebene der Einkoppelflächen angeordnet sind. Dabei wird dieser vertikale Abstand zwischen den Lichtquellen und der Anordnungsebene der Auskoppelflächen jedoch vorteilhafterweise so gering wie möglich gewählt.

Bevorzugt sind die Lichtquellen dieser Ausführungsform gleichsam in einem Verkippungswinkel um eine zur Anzeigenachse senkrechten Achse in Richtung der ihr zugeordneten Einkoppelfläche angeordnet.

Die so realisierte Beleuchtung der einzelnen Kanäle vor der Einkopplung in das Bauteil erfolgt insbesondere bei gegenüberliegenden Edge-Lit Anordnungen gleichsam überkreuz. Durch diese Anordnungen kann trotz des in Bezug auf die optische Qualität der Beleuchtung und der daraus resultierenden Leuchtfunktion optimierten Strahlengangs Bauraum gespart werden.

In einer weiteren bevorzugten Ausführungsform der Erfindung umfasst die Reflektionsfläche einen Parabolspiegel, dessen Brennebene bevorzugt mit einer Emitterfläche der Lichtquelle zusammenfällt, wobei vorzugsweise die Emitterfläche der Lichtquelle eine Ausdehnung bis zu 1 x 1 mm² aufweist und die Lichtquelle und die zugeordnete Reflektionsfläche einen Abstand von mindestens 20 mm aufweisen.

Ein Parabolspiegel ist bevorzugterweise ein Hohlspiegel, welcher die Form eines Rotationsparaboloids aufweist. Eine Parabel ist vorzugsweise eine Menge aller der Punkte, deren Abstand zu einem festen Punkt, dem Brennpunkt, gleich dem zu einer speziellen Geraden, der Leitgeraden ist. Aus der Parabel wird vorzugsweise durch Rotation um ihre Symmetrieachse das Rotationsparaboloid, wobei diese beim Parabolspiegel eine reflektierende Fläche umfasst.

Der Parabolspiegel spiegelt vorteilhafterweise einen senkrecht einfallenden Strahl (ein Strahl parallel zur Symmetrieachse) in Richtung Brennpunkt und umgekehrt. Es kann sich beim Parabolspiegel auch um einen sphärischen Hohlspiegel handeln, welcher nahe zur Symmetrieachse im Wesentlichen ähnliche optische Eigenschaften aufweist und billiger zu fertigen ist.

Eine solche Reflektionsfläche ist vorzugsweise geeignet, das Licht der Lichtquelle als kollimierten Strahl auf die Auskoppelfläche und/oder die holografische Struktur zu lenken. Eine Kollimation findet bevorzugterweise in alle Richtungen senkrecht zur Hauptstrahlrichtung statt. So kann die Auskoppelfläche mit einem Strahl bzw. einem Strahlenbündel mit geringem Winkelspektrum beleuchtet werden und die optische Qualität der Leuchtfunktion erhöht werden.

Vorzugsweise können die Begriffe Strahl und Strahlenbündel in diesem Dokument synonym verwendet werden. Unter einem Strahlenbündel versteht man vorzugsweise eine Mehrzahl von Strahlen, die im Wesentlichen parallel zueinander verlaufen. Der Begriff "Strahl" in diesem Dokument kann vorzugsweise sowohl einen einzelnen Strahl als auch ein Strahlenbündel umfassen.

Bevorzugt kann die Lichtquelle dabei als Punktlichtquelle angenähert werden, wodurch die Kollimation verbessert wird, da die Kollimation eines Strahls am besten ist, wenn die Abweichung des Strahlursprungs vom Brennpunkt so gering wie möglich ist.

Es ist dabei bevorzugt, dass die Lichtquelle und die zugeordnete Reflektionsfläche einen Abstand aufweisen, der eingerichtet ist, so dass die Lichtquelle durch eine Punktlichtquelle approximiert werden kann.

Eine solche Annäherung ist insbesondere gerechtfertigt, wenn die Emitterfläche der Lichtquelle eine Ausdehnung bis zu 1 x 1 mm² aufweist und die Lichtquelle und die zugeordnete Reflektionsfläche einen Abstand von mindestens 20 mm aufweisen. Dann kann die Kollimation des eingekoppelten Strahls der Lichtquelle weiter verbessert werden.

In einer bevorzugten Ausführungsform der Erfindung beträgt ein Verhältnis des Abstands zwischen Lichtquelle und der ihr zugeordneten Einkoppelfläche zu dem Abstand zwischen Lichtquelle und der ihr zugeordneten Reflektionsfläche 0,4 bis 0,85.

Es hat sich herausgestellt, dass hierdurch ein sauberer Strahlengang ohne unerwünschte Reflektionen im Bauteil erzielt werden kann und gleichsam die Reflektionsfläche gut ausgeleuchtet werden kann. Insbesondere wenn die Reflektionsfläche zur Strahlformung geeignet ist, z. B. durch die Reflektionsfläche in Form eines Parabolspiegels, kann bei diesem Abstandverhältnis eine besonders gute Kollimation erzielt werden.

In einer bevorzugten Ausführungsform der Erfindung sind Abmessungen der Vorrichtung kleiner als 80 mm x 50 mm x 50 mm, insbesondere kleiner als 30 mm x 40 mm x 30 mm. Vorrichtungen mit diesen Abmessungen haben sich für eine Vielzahl von Anwendungen, bei denen ein begrenzter Bauraum für die Vorrichtung zur Verfügung steht, als besonders praktisch erwiesen und ermöglicht gleichzeitig die Realisierung von Leuchtfunktionen mit hoher optischer Qualität.

In einer weiteren bevorzugten Ausführungsform der Erfindung ist die holografische Struktur eingerichtet für eine Erzeugung eines identischen Bildes für jeden Kanal, wobei die Leuchtfunktion einer einstellbaren Helligkeit des Bildes entspricht.

Identisches Bild bezeichnet vorzugsweise sowohl das Motiv des Bildes, die farbige Darstellung/das Frequenzspektrum des Bildes als auch den Ort der Abbildung, welcher identisch ist (die identischen Bilder der Kanäle werden vorzugsweise räumlich überlagert). Bei dem Bild handelt es sich insbesondere um eine holographische Abbildung. Erzeugen mehrere Kanäle das gleiche Bild, kann die Einstellbare Helligkeit insbesondere dadurch erfolgen, dass
1. in verschiedenen Kanälen Lichtquellen mit verschiedenen Helligkeiten verwendet werden
2. die Anzahl der gleichzeitig eingeschalteten Kanäle, die das identische Bild erzeugen, variiert wird.

Die Helligkeit kann insbesondere durch eine Kombination von 1. und 2. erfolgen. Durch die Vorrichtung wird diese Art der Helligkeitsregelung insbesondere dadurch ermöglicht, dass die optische Qualität des erzeugten Bildes so gut ist, dass mehrere Bilder unmerklich überlagert werden können, um die Helligkeit zu regulieren. So kann eine verbesserte und besonders einfache Helligkeitsregulierung eines (insbesondere holographischen) Bildes erzielt werden.

In einer weiteren bevorzugten Ausführungsform der Erfindung ist die holografische Struktur eingerichtet für eine Strahlformung von Lichtstrahlen des Kanals, wobei die Strahlformung vorzugsweise ausgesucht ist aus der Gruppe Kollimation, Fokussierung und/oder Zerstreuung (Divergenz).

Hierdurch können die Lichtstrahlen mehrerer LEDs in einem einzigen, je nach Strahlformung geformten Lichtstrahls vereinigt bzw. einzeln hinzugeschaltet werden. So können unterschiedliche Funktionalitäten erfüllt werden, z. B. die Beleuchtung einer Probe mit Licht unterschiedlicher Spektren (Licht der verschiedenen Kanäle).

Es ergibt sich vorteilhafterweise eine homogen ausgeleuchtete Fläche, die Auskoppelfläche und/oder die holografische Struktur, welche strahlgeformtes, z. B. kollimiertes Licht emittiert (mit konventionellen Lösungen des Standes der Technik gibt es entweder das eine oder das andere). Vorteilhaft wäre zudem, dass mehrere Lichtquellen, z. B. mehrere LEDs in das System eingekoppelt werden könnten. Solche Systeme könnten u.a. in der Messtechnik Anwendung finden.

Eine entsprechende holografische Struktur kann bspw. mit dem Ziel einer Kollimation hergestellt werden, indem die holografische Struktur mit zwei ebenen Wellen aufgenommen wird. Somit wird bevorzugt bei gegebenem Rekonstruktionssetup wieder eine ebene Welle rekonstruiert bzw. ausgekoppelt.

Eine Homogenität des ausgekoppelten Strahles kann dabei bevorzugt über die Effizienz der jeweiligen holografischen Struktur gesteuert werden. So entsteht eine große Flexibilität bei der Strahlformung.

In einer weiteren bevorzugten Ausführungsform der Erfindung weist die Einkoppelfläche eine Verrundung an Außenkanten auf, welche bevorzugt eingerichtet ist für eine Unterdrückung unerwünschter Totalreflektionen an nicht-funktionalen Außenflächen des Bauteils, wobei ein Verrundungsradius insbesondere zwischen 0,5 Millimeter (mm) und 2 mm liegt.

Da Einkoppel- und Reflexionsfläche einen Abstand besitzen, hat auch die Oberseite bzw. (obere) Verbindungsfläche zwischen Einkoppelfläche und Reflektionsfläche eine endliche Ausdehnung d, an der Strahlen totalreflektiert werden können. Um diese Strahlen abzuschatten bzw. gezielt zu streuen, können vorzugsweise Verrundungen an Außenkanten der Einkoppelfläche eingeführt werden. Die Größe ist dabei vorzugsweise von dem Beschnitt der Oberseite und der Größe von d abhängig (z.B. je kleiner d desto kleiner das Störlicht). Dabei sind Radien im Bereich 0,5 mm typischerweise etwas aufwendiger in der Fertigung als größere Radien im Bereich 2 mm. Dies ist jedoch insbesondere von der Lage der Verrundung am/im Bauteil und/oder dem eingesetzten Fräswerkszeug abhängig.

In einer weiteren bevorzugten Ausführungsform der Erfindung ist die Verbindungsfläche zwischen Einkoppelfläche und Reflektionsfläche verkippt für eine Unterdrückung unerwünschter Totalreflektionen an nicht-funktionalen Außenflächen des Bauteils.

Es ist bevorzugt, dass die Verbindungsfläche zwischen Einkoppelfläche und Reflektionsfläche normalerweise eine gerade Verbindung zwischen den oberen Kanten der Einkoppelfläche und der Reflektionsfläche darstellt, wobei diese oberen Kanten vorzugsweise angeordnet sind für einen ungehinderten Verlauf eines wesentlichen bzw. überwiegenden Anteils der eingekoppelten Strahlen bzw. zur Einkopplung der Strahlen entlang einer gewünschten Richtung. Trotzdem können insbesondere durch Strahlablenkungen an den Außenkanten der Einkoppelfläche an der Verbindungsfläche unerwünschterweise Strahlen totalreflektiert werden. Eine etwas verkippte Verbindungsfläche, so dass die obere Kante, an der die Verbindungsfläche die Reflektionsfläche trifft, etwas höher liegt als im vorstehend beschriebenen Normalfall, kann solch unerwünschte Totalreflektion vermindern. Eine solche verkippte Verbindungsfläche ist insbesondere als Alternative oder Ergänzung zu den vorstehend genannten Verrundungen geeignet.

Dabei können die Verrundungen auch eine fertigungstechnische Bewandtnis aufweisen, um z. B. das Bauteil über einen Fräsprozess herzustellen. Dabei sind i.d.R. Verrundungen oft erwünscht (z. B. um die Geometrie des Fräsers optimal zu nutzen oder um Abnutzung beim Abformprozess zu tolerieren). Um reproduzierbare, serientaugliche Teile sicherzustellen, kann es deshalb bevorzugt sein, Kanten eines Objekts zu verrunden. Somit kann durch die Verrundung sowohl ein optischer als auch ein fertigungstechnischer Vorteil erzielt werden.

In einer bevorzugten Ausführungsform enthält das monolithische Bauteil einen für den Spritzguss geeigneten optischen Kunststoff.

In einer besonders bevorzugten Ausführungsform enthält das monolithische Bauteil ein Material ausgesucht aus der Gruppe umfassend Polymethylmethacrylat (PMMA), Polycarbonat, Cyclic Olefin Polymer (COP) und/oder Cycloolefin-Copolymere (COC).

In einer bevorzugten Ausführungsform enthält das monolithische Bauteil mindestens ein Glas mit einer niedrigen Transformationstemperatur (sogenanntes Low Tg-Glas), welches insbesondere für Blankpressen bzw. Präzisionsblankpressen geeignet ist.

Insbesondere enthält das monolithische Bauteil ein Material ausgesucht aus der Gruppe Borosilikatglas, B270, N-BK7, N-SF2, P-SF68, P-SK57Q1, P-SK58A und/oder P-BK7

Diese Materialien sind besonders gut zu verarbeiten, gut geeignet für die Massenproduktion, günstig und/oder besitzen besonders gute optische Eigenschaften.

In einer weiteren bevorzugten Ausführungsform der Erfindung ist das monolithische Bauteil fertigungsgerecht geformt und/oder weist keine Hinterschnitte auf.

In einer weiteren bevorzugten Ausführungsform der Erfindung ist das monolithische Bauteil fertigungsgerecht geformt und/oder weist Ausformschrägungen und/oder Verrundungen auf.

In einer weiteren bevorzugten Ausführungsform der Erfindung ist das monolithische Bauteil fertigungsgerecht geformt und/oder weist Ausformschrägungen und/oder Verrundungen, aber keine Hinterschnitte auf.

Hinterschnitt ist vorzugsweise synonym mit Hinterschneidung. Als Hinterschneidung wird z. B. ein Konstruktionselement bezeichnet, das frei hervorsteht und damit z. B. bei einem Gussteil verhindern kann, dass sich dieses aus seiner Gussform entfernen lässt. Daher ist die Vermeidung eines Hinterschnitts für eine einfache und kostengünstige Massenproduktion besonders günstig.

Eine Ausformschrägung bezeichnet vorzugsweise die minimal nötige Abweichung von einer Senkrechten zur Formteilung. Gängige Größen für die notwendigen Ausformschrägen sin dem Fachmann bekannt.

Eine Verrundung bezeichnet insbesondere eine Verrundung einer Bauteilkante. Wie vorstehend erwähnt, sind insbesondere Verrundungen mit einem Radius im Bereich von oder größer als 2 mm bei der Massenfertigung besonders günstig zu realisieren.

Daher können Verrundungen und Ausformschrägungen sowie ein Verzicht auf Hinterschnitte die Fertigung verbilligen.

In einer weiteren bevorzugten Ausführungsform der Erfindung sind Blenden umfasst, welche vorzugsweise eingerichtet sind, ein Einstrahlen unerwünschter Lichtstrahlen und/oder ein Übersprechen/die Unterdrückung der Einstrahlung in benachbarte Kanäle zu verhindern.

Diese sind bspw. so angeordnet, dass das emittierte Licht einer einem Kanal zugeordneten LED nur in die jeweils zugeordnete Einkoppelfläche einstrahlen kann, um ein Übersprechen in benachbarte Kanäle oder ein Einkoppeln in nicht dafür vorgesehene Flächen zu verhindern.

So kann ein Übersprechen zwischen den Kanälen verhindert und die Trennung der Kanäle verbessert werden.

In einer weiteren bevorzugten Ausführungsform der Erfindung nimmt eine Hauptrichtung von der Auskoppelfläche ausgekoppelter Lichtstrahlen einen Winkel von +30° bis -30° in einer Ebene mit einer Flächennormalen der Auskoppelfläche ein bzw. einen Raumwinkel um die Flächennormale der Auskoppelfläche von ungefähr 0,2141 Steradiant.

So können besonders gut für einen Benutzer sichtbare Leuchtfunktionen erzeugt werden.

In einem weiteren Aspekt betrifft die Erfindung ein monolithisches Bauteil umfassend Edge-Lit-Anordnungen für eine holographische Anzeige gemäß der vorstehenden Beschreibung.

Dem Fachmann ist ersichtlich, dass Vorteile, Definitionen und Ausführungsformen der erfindungsgemäßen holographischen Leuchtvorrichtung ebenso für das beanspruchte erfindungsgemäße monolithische Bauteil gelten.

In einem weiteren Aspekt betrifft die Erfindung ein Fahrzeug umfassend mindestens eine holographisches Leuchtvorrichtung nach der vorstehenden Beschreibung, wobei die holographische Leuchtvorrichtung eingerichtet ist zu einer Anzeige mindestens einer von mehreren möglichen Informationen betreffend eine Fahrsituation, wobei eine Information einem Kanal der Vorrichtung zugeordnet ist, wobei die holographische Leuchtvorrichtung bevorzugt in einer A-Säule, einer B-Säule und/oder einer C-Säule des Fahrzeugs angeordnet vorliegt, wobei die holographische Leuchtvorrichtung insbesondere eine Anzeige eines Spurwechselassistenten umfasst.

Die holographische Leuchtvorrichtung kann auch an einem anderen Ort, insbesondere im Innenraum des Fahrzeugs vorliegen.

Die relevanten Fahrsituationen für eine Anzeige eines Spurwechselassistenten umfassen dabei insbesondere Informationen zu weiteren Objekten, insbesondere Fahrzeugen, in der Umgebung des Fahrzeugs, welche insbesondere eine Relevanz für die Fahrsicherheit bei einem Spurwechsel des Fahrzeugs haben. Ein Beispiel kann eine detektierte Anwesenheit eines Fahrzeugs in einem toten Winkel des Außenspiegels des Fahrzeugs haben. Dabei können durch die mehreren möglichen Informationen z. B. eine Anzeige der Gefährlichkeit einer Situation umfassen, welche sich bspw. durch eine Nähe eines anderen Fahrzeugs ergibt. Z. B. kann die Anzeige ein Hologramm eines symbolischen Fahrzeugs oder eines warnenden Dreiecks in verschiedenen Größen und/oder Farben je nach Gefährlichkeit umfassen. Die Farbe kann sich bspw. mit zunehmender Gefährlichkeit von grün über gelb und orange zu rot entwickeln. Oder mit abnehmendem Abstand eines anderen Fahrzeugs wird das angezeigte symbolische Fahrzeug immer größer oder näher zum Fahrer angezeigt. Solche verschiedenen Leuchtfunktionen können vorteilhafterweise durch die holographische Leuchtvorrichtung realisiert werden, welche gleichzeitig aufgrund ihrer Kompaktheit in einem Fahrzeug untergebracht werden kann, insbesondere in einer A-, B- oder C-Säule.

Dem Fachmann ist ersichtlich, dass Vorteile, Definitionen und Ausführungsformen der erfindungsgemäßen Vorrichtung ebenso für das beanspruchte, erfindungsgemäße Fahrzeug gelten.

In einem weiteren Aspekt betrifft die Erfindung die Verwendung einer holographischen Leuchtvorrichtung nach der vorstehenden Beschreibung zu einer Anzeige mindestens einer von mehreren möglichen Informationen, insbesondere in einem Fahrzeug betreffend eine Fahrsituationen, wobei die Information einem Kanal der Vorrichtung zugeordnet ist und wobei zur Anzeige der Information eine Beleuchtung der holografischen Struktur durch die dem Kanal zugeordnete Lichtquelle vorgenommen wird.

Dem Fachmann ist ersichtlich, dass Vorteile, Definitionen und Ausführungsformen der erfindungsgemäßen Vorrichtung ebenso für die beanspruchte erfindungsgemäße Verwendung der Vorrichtung gelten.

In einem weiteren Aspekt betrifft die Erfindung die Verwendung einer holographischen Leuchtvorrichtung nach der vorstehenden Beschreibung zu einer Anzeige mindestens einer von mehreren möglichen Informationen für ein Bedienelement, insbesondere in einem Fahrzeug, wobei die Information einem Kanal der Vorrichtung zugeordnet ist und wobei zur Anzeige der Information eine Beleuchtung der holografischen Struktur durch die dem Kanal zugeordnete Lichtquelle vorgenommen wird.

Dem Fachmann ist ersichtlich, dass Vorteile, Definitionen und Ausführungsformen der erfindungsgemäßen Vorrichtung ebenso für die beanspruchte erfindungsgemäße Verwendung der Vorrichtung gelten.

Das Bedienelement kann beispielsweise eine Anzeigeleiste umfassen, welche z. B. die gewählte oder tatsächliche Temperatur in einem Fahrzeug anzeigt, bspw. in blau bei niedrigeren Temperaturen bspw. unter 20° und rot bei höheren Temperaturen. Die Temperatur kann in einem adäquaten Bereich angezeigt werden, z. B. von 14-28° in 0,5° Schritten. Auch eine holografische Leuchte zur Anzeige der eingeschalteten Warnblinkanlage oder wechselnde Symbole, z. B. der Klimatisierung, können durch eine einzige Leuchtvorrichtung realisiert werden. Es kann ebenfalls bevorzugt sein, durch die verschiedenen Kanäle der Leuchtvorrichtung gleichbleibende Symbole, jedoch mit verschiedenen Farben durch die Leuchtvorrichtung zu erzeugen.

Auch ein Schalter mit wechselnden Funktionalitäten, welche jeweils durch die Leuchtvorrichtung zur Information angezeigt werden können, kann so realisiert werden.

Der Schalter kann bspw. als ein Druckschalter in Kombination mit einer innerhalb der Auskoppelfläche erzeugten Leuchtfunktion realisiert werden.

Dabei ergeben sich vorteilhafterweise durch die durch die holografische Struktur möglichen 3D-Darstellungen besondere Darstellungsmöglichkeiten.

In einem weiteren Aspekt betrifft die Erfindung die Verwendung einer holographischen Leuchtvorrichtung gemäß der vorstehenden Beschreibung als LED-Kollimator, insbesondere für eine messtechnische Anwendung und/oder Vorrichtung.

Dem Fachmann ist ersichtlich, dass Vorteile, Definitionen und Ausführungsformen der erfindungsgemäßen Vorrichtung ebenso für die beanspruchte erfindungsgemäße Verwendung der Vorrichtung gelten.

Dadurch kann insbesondere eine telezentrische, homogene Beleuchtung realisiert werden, wie sie beispielsweise im Schattenrissverfahren Anwendung findet.

### Beschreibung der Erfindung:

Die Erfindung soll im Folgenden unter Verweis auf weitere Abbildungen und Beispiele erläutert werden.
**Figur 1** zeigt eine perspektivische Ansicht einer ersten, nicht beanspruchten Ausführungsform der Vorrichtung mit zwei Kanälen und im Innenbereich des Bauteils angeordneten Lichtquellen.
**Figur 2** zeigt eine Querschnittsansicht der ersten Ausführungsform mit zwei Kanälen mit einem ersten eingeschalteten Kanal.
**Figur 3** zeigt eine Querschnittsansicht der ersten Ausführungsform mit zwei Kanälen mit einem zweiten eingeschalteten Kanal.
**Figur 4** zeigt eine perspektivische Ansicht der ersten Ausführungsform zur Darstellung des azimutalen Anordnungswinkels.
**Figur 5** zeigt eine Vermessung verschiedener Messgrößen der Leuchtfunktion beider Kanäle der Vorrichtung gemäß der ersten Ausführungsform.
**Figur 6** zeigt eine zweite Vermessung verschiedener Messgrößen der Leuchtfunktion beider Kanäle der Vorrichtung gemäß der ersten Ausführungsform.
**Figur 7** zeigt eine perspektivische Ansicht einer zweiten, beanspruchten Ausführungsform der Vorrichtung mit
zwei Kanälen und entlang eines Randbereichs der seitlichen Außenfläche der Vorrichtung angeordneten Lichtquellen oberhalb der Anordnungsebene der Einkoppelflächen.
**Figur 8** zeigt eine Querschnittsansicht der zweiten Ausführungsform mit zwei Kanälen mit einem ersten eingeschalteten Kanal.
**Figur 9** zeigt eine Querschnittsansicht der zweiten Ausführungsform mit zwei Kanälen mit einem zweiten eingeschalteten Kanal.
**Figur 10** zeigt eine zweite perspektivische Ansicht der zweiten Ausführungsform der Vorrichtung mit zwei Kanälen.
**Figur 11** zeigt eine Querschnittsansicht der zweiten Ausführungsform mit beiden Kanälen eingeschaltet.
**Figur 12** zeigt eine Vermessung verschiedener Messgrößen der Leuchtfunktion beider Kanäle der Vorrichtung gemäß der zweiten Ausführungsform.
**Figur 13** zeigt eine zweite Vermessung verschiedener Messgrößen der Leuchtfunktion beider Kanäle der Vorrichtung gemäß der zweiten Ausführungsform.
**Figur 14** zeigt eine perspektivische Ansicht der Vorrichtung gemäß der zweiten Ausführungsform und vier Kanälen.
**Figur 15** verdeutlich anhand einer schematischen Ansicht die Auswirkung der Abstände der verschiedenen Elemente der Anordnung auf den Strahlenverlauf.
**Figur 16** zeigt schematisch eine Ausführungsform der Vorrichtung mit einer Verrundung an einer Außenkante der Einkoppelfläche.
**Figur 17** zeigt schematisch eine Ausführungsform der Vorrichtung mit einer verkippten Verbindungsfläche zwischen Einkoppelfläche und Reflektionsfläche.
**Figur 18** zeigt schematisch eine reflektive holographische Struktur, die nicht auf der Auskoppelfläche, sondern auf einer zu dieser parallelen Fläche angeordnet ist, welcher der Auskoppelfläche gegenüberliegt.
**Figur 19** zeigt mögliche angezeigte Elemente bei einer Verwendung der holographischen Leuchtvorrichtung zu einer Anzeige mindestens einer von mehreren möglichen Informationen für ein Bedienelement in einem Fahrzeug.

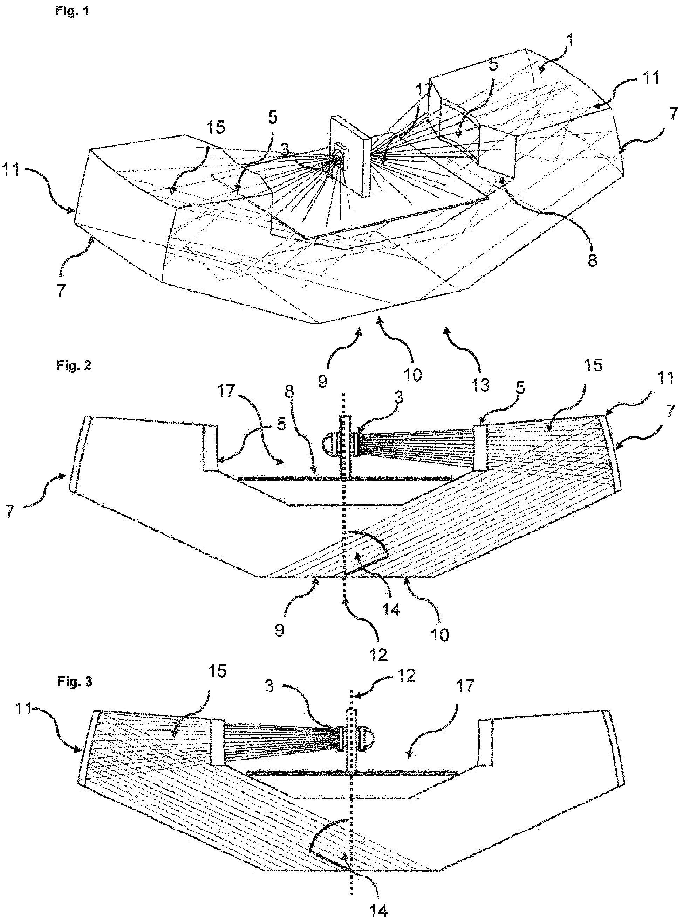

**Figur 1** zeigt eine perspektivische Ansicht einer ersten, nicht beanspruchten Ausführungsform der holographischen Leuchtvorrichtung **1** mit zwei Kanälen und im Innenbereich des Bauteils **17** angeordneten Lichtquellen **3.** Das Licht jeder Lichtquelle **3** wird über die ihr zugeordnete Einkoppelfläche **5** eingekoppelt, die eingekoppelten Lichtstrahlen **15** werden sodann an der Reflektionsfläche **7** reflektiert. Die reflektierten Lichtstrahlen erwirken die direkte reflektive Beleuchtung der Auskoppelfläche **9,** auf der die holografische Struktur **10** jedes Kanals vorliegt, die bei der Beleuchtung durch die Lichtquelle des Kanals die holographische Leuchtfunktion erzeugt. Eine Edge-Lit Anordnung **11** umfasst eine Einkoppelfläche **5,** vorzugsweise eine Reflektionsfläche **7** und eine Auskoppelfläche **9,** auf der die holografische Struktur **10** vorliegen kann. Ein Kanal umfasst dabei eine Edge-Lit Anordnung **11** und eine Lichtquelle **3.** Im gezeigten Ausführungsbeispiel sind zwei gegenüberliegende Edge-Lit Anordnungen **11** in einem monolithischen Bauteil **15** umfasst und die Auskoppelfläche **9** beider Edge-Lit Anordnungen 11 ist eine gemeinsame Auskoppelfläche **9.** Die Edge-Lit Anordnungen **11** sind zwei gegenüberliegende Edge-Lit Anordnungen **11,** deren azimutaler Anordnungswinkel zu einer Flächennormalen der Auskoppelfläche (nicht gezeigt) sich um 180° unterscheidet. Figur 1 zeigt ebenfalls eine Blende **8** an einer Seitenfläche neben der Einkoppelfläche **5,** welche ein Einstrahlen unerwünschter Lichtstrahlen in das Bauteil **13** minimieren soll.

**Figur 2** zeigt eine Querschnittsansicht der ersten, nicht beanspruchten Ausführungsform mit zwei Kanälen mit einem ersten eingeschalteten Kanal. Der eingeschaltete Kanal ist über die in der gezeigten Ansicht rechte Edge-Lit Anordnung **11** und die im Innenbereich des Bauteils **17** rechte Lichtquelle **3** realisiert. Diese Lichtquelle **3** ist eingeschaltet. Die über die rechte Einkoppelfläche **5** eingekoppelten Lichtstrahlen **15** werden durch die Reflektionsfläche **7** reflektiert. Die direkte reflektive Beleuchtung der Auskoppelfläche **9** und somit in diesem Beispiel auch der holografischen Struktur **10** erfolgt in bzw. unter einem Polarwinkel **14** mit der Flächennormalen der Auskoppelfläche **12.** Die holografische Struktur **10** ist eingerichtet für eine Erzeugung der holografischen Leuchtfunktion bei Beleuchtung unter dem Polarwinkel (und vorzugsweise unter im Wesentlichen keinem anderen Polarwinkel). Im gezeigten Ausführungsbeispiel wird der Polarwinkel **14** ausgehend von der Flächennormalen der Auskoppelfläche entgegen dem Uhrzeigersinn gezählt und beträgt somit -Θ. In Figur 2 ist ein weiteres Blendenelement **8** gezeigt, welche verhindert, dass Licht, welches von der Lichtquelle **3** "nach unten" abgestrahlt wird, in das Bauteil **13** eingekoppelt wird.

**Figur 3** zeigt eine Querschnittsansicht der ersten, nicht beanspruchten Ausführungsform mit zwei Kanälen mit einem zweiten eingeschalteten Kanal. Der zweite eingeschaltete Kanal entspricht in der gezeigten Ansicht der linken Edge-Lit Anordnung **11** und der linken Lichtquelle **3.** Bei eingeschaltetem linkem Kanal erfolgt die direkte reflektive Beleuchtung der Auskoppelfläche **9** und somit der zugeordneten holografischen Struktur **10** unter dem Polarwinkel **14** mit der Flächennormalen der Auskoppelfläche **12.** Der Polarwinkel **14** wird weiterhin entgegen dem Uhrzeigersinn positiv gelesen und beträgt somit +Θ. Die holgrafische Struktur **10** des eingeschalteten Kanals ist eingerichtet für eine Erzeugung der holografischen Leuchtfunktion unter diesem Polarwinkel **14** (und vorzugsweise unter im Wesentlichen keinem anderen Polarwinkel **14).**

Somit werden Leuchtfunktion für den jeweiligen Kanal vorzugsweise nur erzeugt, wenn die Lichtquelle **3** des jeweiligen Kanals eingeschaltet ist und die dem Kanal zugeordnete holografische Struktur unter dem Polarwinkel **14** mit der Flächennormalen der Auskoppelfläche **12** beleuchtet wird. So können Leuchtfunktionen der beiden gegenüberliegenden Kanäle mit den beiden gegenüberliegenden Edge-Lit Anordnungen **11** sehr gut getrennt werden.

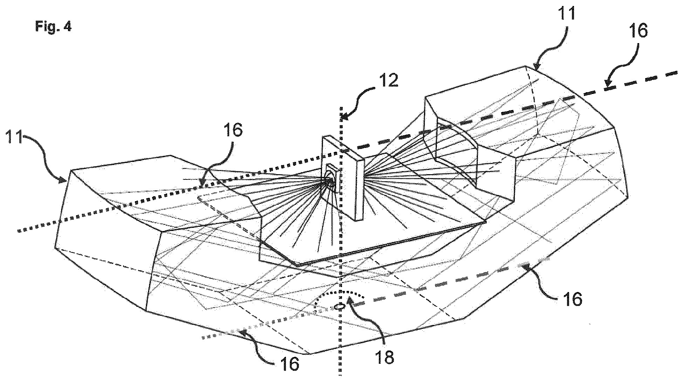

**Figur 4** zeigt eine perspektivische Ansicht der ersten, nicht beanspruchten Ausführungsform zur Darstellung des azimutalen Anordnungswinkels **18.** Der rechte Kanal mit der rechten Lichtquelle und der rechten Edge-Lit Anordnung **11** ist entlang eines ersten azimutalen Anordnungsrichtung **16** mit einem ersten azimutalen Anordnungswinkel **16** um die Flächennormale der Auskoppelfläche **12** angeordnet. Dieser wird im gezeigten Beispiel mit 0° angenommen (nicht gezeigt). Die zweite, gegenüberliegende, linke Edge-Lit Anordnung **11** ist mit entlang einer zweiten azimutalen Anordnungsrichtung **16** entlang eines zweiten azimutalen Anordnungswinkels **18** um die Flächennormale der Auskoppelfläche **12** angeordnet. Entsprechend der vorgenommenen Winkelfestlegung beträgt dieser bevorzugt gegen den Uhrzeigersinn abzulesende azimutale Anordnungswinkel **18** 180°.

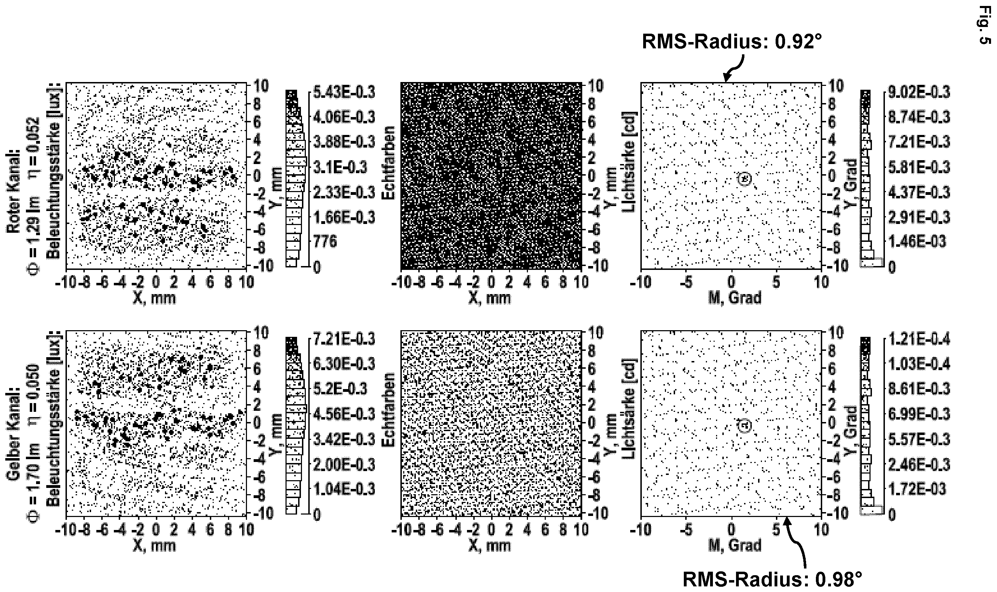

**Figur 5** zeigt eine Vermessung verschiedener Messgrößen der Leuchtfunktion beider Kanäle der Vorrichtung gemäß der ersten, nicht beanspruchten Ausführungsform. Dabei erzeugen die beiden Kanäle Leuchtfunktionen in unterschiedlichen Farben. Ein erster Kanal erzeugt eine holographische Anzeige in rot und wird gemäß Abbildung als "roter Kanal" bezeichnet. Ein zweiter Kanal erzeugt eine holographische Anzeige in Gelb und wird fortan gemäß Abbildung als "gelber Kanal" bezeichnet.

Die beiden unteren linken und rechten Grafen bilden die Beleuchtungsstärke in Lux (lux, Ix) des "roten Kanals" (linke Seite unten) und des "gelben Kanals" (rechte Seite unten) ab. Lux ist vorzugsweise die SI-Einheit der Beleuchtungsstärke. Die Maßeinheit Lux ist bevorzugt definiert als die photometrische Beleuchtung, die ein Lichtstrom von 1 Lumen (Im) erzeugt, wenn er sich gleichmäßig über eine Fläche von 1 Quadratmeter verteilt. Die Skala oberhalb der der beiden Grafen ermöglicht bevorzugt eine Zuordnung der graphisch dargestellten, verschiedenen Punktdichten innerhalb der Graphen zu einem konkreten Wert der Beleuchtungsstärke. Aus der Darstellung der Beleuchtungsstärke lässt sich das Maß der Homogenität der Ausleuchtung der Auskoppelfläche bestimmen. Auf einem Großteil der Fläche gilt vorteilhafterweise Iₘᵢₙ/Iₘₐₓ > 0.8 und somit eine homogene Ausleuchtung. Intensitäten von 3,88E-0,3 oder größer, welche teilweise erkennbar sind, sind nur punktuell vorhanden und stellen keine zusammenhänge Gebiete mit einer größeren Intensität dar. In weiten Teilen liegt die Beleuchtungsstärke in etwa bei 3,1E-0,3.

Die beiden mittleren linken und rechten Grafen sollen die farbliche Homogenität der Kanäle (hier in schwarz-weiß) darstellen. In der schwarz-weißen Darstellung ist hier insbesondere die hohe farbliche Homogenität erkennbar, dass bis auf wenige punktuelle Abweichungen ein im Wesentlichen einheitlichen Punktemuster mit einer im Wesentlichen einheitlichen Punktedichte vorherrscht, welches einer im Wesentlichen einheitlichen Farbe des jeweiligen Kanals entspricht, nämlich rot für den "roten Kanal" (links) und gelb für den "gelben Kanal" (rechts). Somit ist vorteilhafterweise die hohe farbliche Homogenität der Kanäle erkennbar. Dies ist insbesondere bemerkenswert, da beide Kanäle über eine großflächige Auskopplung der gleichen Auskoppelfläche 9 realisiert werden. Somit ist vorteilhafterweise ebenfalls ersichtlich, wie gut die Kanäle voneinander getrennt werden können.

Die beiden oberen Grafen bilden die gemessene Lichtstärke des "roten Kanals" (links) und des "gelben Kanals" (rechts) ab. Die Lichtstärke gibt vorzugsweise den auf den Raumwinkel bezogenen Lichtstrom an. Ihre SI-Einheit ist die Candela (cd). Lichtstrom ist bevorzugt eine photometrische Größe, welche das für das menschliche Auge wahrnehmbare abgestrahlte Licht einer Lichtquelle pro Zeiteinheit angibt. Er berücksichtigt vorzugsweise neben der physikalischen (radiometrischen) Strahlungsleistung die Empfindlichkeit des menschlichen Auges. Er wird in der Maßeinheit Lumen (Im) angegeben. Die Lichtstärke ist vorzugsweise definiert durch dΦ_{V}/dΩ, wobei dΩ bevorzugt ein infinitesimales Raumwinkelelement beschreibt und dΦ_{V} den Lichtstromanteil in dem Raumwinkelelement dΩ. Aus der Darstellung der Lichtstärke lässt sich das Winkelspektrum und das Maß der Kollimation bestimmen. Zur Bewertung wird aus diesen Daten ein Schwerpunktswinkel und ein RMS-Radius bestimmt. Der RMS-Radius des linken, roten Kanals beträgt 0,92° und der RMS-Radius des rechten, gelben Kanals beträgt 0,98°. Auch hier ermöglicht die Skala oberhalb der beiden Grafen eine Zuordnung der graphisch dargestellten, verschiedenen Punktdichten innerhalb der Graphen zu einem konkreten Wert des Lichtstroms. Bis auf in der Mitte der Grafik ist die Intensität sehr niedrig. Es sind keine Nebenmaxima neben dem Maximum bei etwa 0° ersichtlich. Dies belegt die optimale Strahlführung der Vorrichtung.

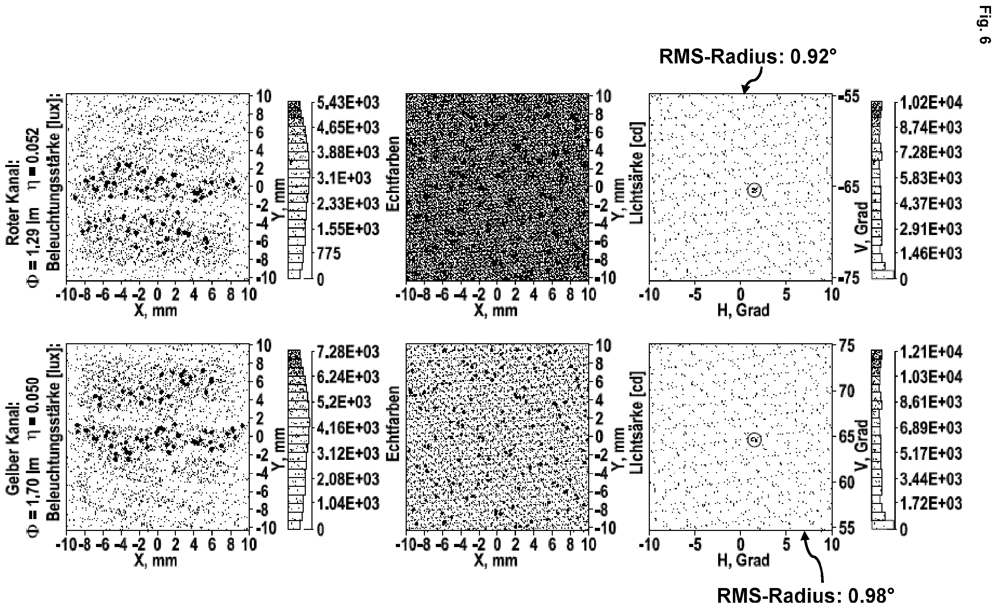

**Figur** 6 zeigt eine zweite Vermessung bzw. eine Simulation verschiedener Messgrößen der Leuchtfunktion beider Kanäle der Vorrichtung gemäß der ersten, nicht beanspruchten Ausführungsform. Dabei erzeugen die beiden Kanäle Leuchtfunktionen in unterschiedlichen Farben. Ein erster Kanal erzeugt eine holographische Anzeige in rot und wird gemäß Abbildung als "roter Kanal" bezeichnet. Ein zweiter Kanal erzeugt eine holographische Anzeige in Gelb und wird fortan gemäß Abbildung als "gelber Kanal" bezeichnet.

Die beiden unteren linken und rechten Grafen bilden die Beleuchtungsstärke in Lux (lux, Ix) des "roten Kanals" (linke Seite unten) und des "gelben Kanals" (rechte Seite unten) ab. Lux ist vorzugsweise die SI-Einheit der Beleuchtungsstärke. Die Maßeinheit Lux ist bevorzugt definiert als die photometrische Beleuchtung, die ein Lichtstrom von 1 Lumen (Im) erzeugt, wenn er sich gleichmäßig über eine Fläche von 1 Quadratmeter verteilt. Die Skala oberhalb der der beiden Grafen ermöglicht eine Zuordnung der graphisch dargestellten, verschiedenen Punktdichten innerhalb der Graphen zu einem konkreten Wert der Beleuchtungsstärke. Die Länge der dort abgebildeten Balken mit den verschiedenen Punktdichten gibt bevorzugt die Fläche bzw. die Häufigkeit der jeweiligen gemessenen Beleuchtungsstärken auf einer logarithmischen Skala an, welche die Abstufungen ,1' **53,** ,10' **55** und ,100' **57** aufweist. Aus der Darstellung der Beleuchtungsstärke lässt sich das Maß der Homogenität der Ausleuchtung der Auskoppelfläche bestimmen. Auf einem Großteil der Fläche gilt vorteilhafterweise Iₘᵢₙ/Iₘₐₓ > 0.8 und somit eine homogene Ausleuchtung. Intensitäten von 4,65E+0,3 oder größer, welche teilweise erkennbar sind, sind nur punktuell vorhanden und stellen keine zusammenhänge Gebiete mit stark abweichenden Intensitäten dar. In weiten Teilen der Fläche erfüllt die Beleuchtungsstärke vorteilhafterweise die erwünschte Homogenität.

Die beiden mittleren linken und rechten Grafen sollen die farbliche Homogenität der Kanäle (hier in schwarz-weiß) darstellen. In der schwarz-weißen Darstellung ist insbesondere erkennbar, dass bis auf wenige punktuelle Abweichungen ein im Wesentlichen einheitlichen Punktemuster mit einer im Wesentlichen einheitlichen Punktedichte vorherrscht, welches einer im Wesentlichen einheitlichen Farbe des jeweiligen Kanals entspricht, nämlich rot für den "roten Kanal" (links) und gelb für den "gelben Kanal" (rechts). Somit ist vorteilhafterweise die hohe farbliche Homogenität der Kanäle erkennbar. Dies ist insbesondere bemerkenswert, da beide Kanäle über eine großflächige Auskopplung der gleichen Auskoppelfläche **9** realisiert werden. Somit ist vorteilhafterweise ebenfalls ersichtlich, wie gut die Kanäle voneinander getrennt werden können.

Die beiden oberen Grafen bilden die gemessene Lichtstärke des "roten Kanals" (links) und des "gelben Kanals" (rechts) ab. Die Lichtstärke gibt vorzugsweise den auf den Raumwinkel bezogenen Lichtstrom an. Ihre SI-Einheit ist die Candela (cd). Lichtstrom ist bevorzugt eine photometrische Größe, welche das für das menschliche Auge wahrnehmbare abgestrahlte Licht einer Lichtquelle pro Zeiteinheit angibt. Er berücksichtigt vorzugsweise neben der physikalischen (radiometrischen) Strahlungsleistung die Empfindlichkeit des menschlichen Auges. Er wird in der Maßeinheit Lumen (Im) angegeben. Die Lichtstärke ist vorzugsweise definiert durch dΦ_{V}/dΩ, wobei dΩ bevorzugt ein infinitesimales Raumwinkelelement beschreibt und dΦ_{V} den Lichtstromanteil in dem Raumwinkelelement dΩ. Aus der Darstellung der Lichtstärke lässt sich das Winkelspektrum und das Maß der Kollimation bestimmen. Zur Bewertung wird aus diesen Daten ein Schwerpunktswinkel und ein RMS-Radius bestimmt. Der RMS-Radius des linken, roten Kanals beträgt 0,92° und der RMS-Radius des rechten, gelben Kanals beträgt 0,98°. Auch hier ermöglicht die Skala oberhalb der beiden Grafen eine Zuordnung der graphisch dargestellten, verschiedenen Punktdichten innerhalb der Graphen zu einem konkreten Wert des Lichtstroms.

Die Länge der dort abgebildeten Balken mit den verschiedenen Punktdichten gibt bevorzugt die Fläche bzw. die Häufigkeit der jeweiligen gemessenen Lichtströme auf einer logarithmischen Skala an, welche die Abstufungen ,1' **53,** ,10' **55** und ,100' **57** aufweist. Bis auf in der Mitte der Grafik ist die Intensität sehr niedrig. Es sind keine Nebenmaxima neben dem Maximum bei etwa 0° ersichtlich. Dies belegt die optimale Strahlführung der Vorrichtung.

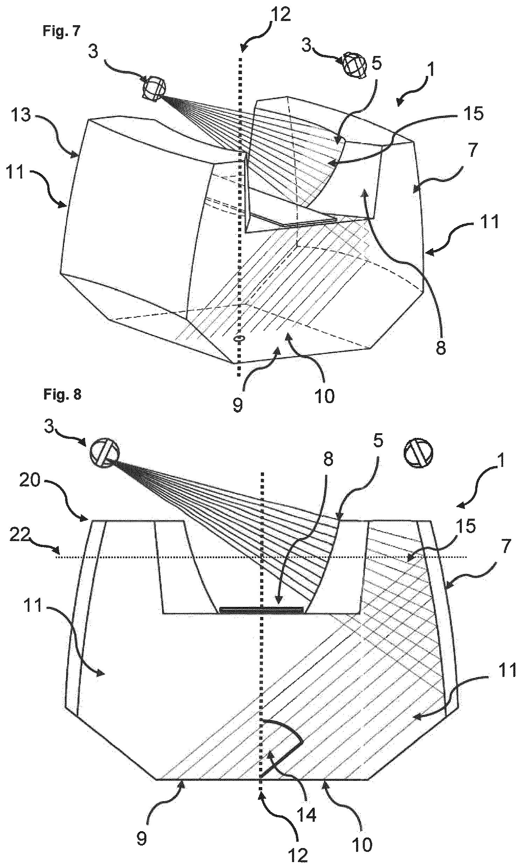

**Figur 7** zeigt eine perspektivische Ansicht einer zweiten, beanspruchten Ausführungsform der Vorrichtung mit zwei Kanälen und entlang eines Randbereichs der seitlichen Außenfläche **20** der Vorrichtung angeordneten Lichtquellen **3** oberhalb der Anordnungsebene der Einkoppelflächen. Jede Lichtquelle 3 strahlt in einem Neigungswinkel Licht in die ihr zugeordnete Einkoppelfläche 5. Das eingekoppelte Licht trifft sodann auf die Reflektionsfläche **7.** Der Winkel, mit dem das eingekoppelte Licht **15** auf die Reflektionsfläche **7** trifft, ist größer als bei der ersten Ausführungsform und wird dementsprechend auch unter einem größeren Winkel von der Reflektionsfläche **7** auf die Auskoppelfläche **9** reflektiert, auf der in diesem Beispiel die holografische Struktur **10** vorliegt. Dadurch kann ein Abstand zwischen Einkoppelfläche **5** und Reflektionsfläche **7** kürzer sein, ohne dass ein wesentlicher Teil des eingekoppelten Lichtstrahls **15** von Grenzflächen des monolithischen Bauteils **13** abgeschnitten wird. So kann das Bauteil **13** kompakter gestaltet werden. Gleichzeitig kann bei dieser Ausführungsform der Abstand zwischen Lichtquelle **3** und der ihr zugeordneten Einkoppelfläche **5** groß gehalten werden, da die Lichtquellen **3** sich nicht gegenseitig behindern, sondern über Kreuz in die ihnen jeweils zugeordneten Einkoppelflächen **5** einleuchten. Es ist erkennbar, dass auch in diesem Ausführungsbeispiel beide Edge-Lit Anordnungen **11** in einem azimutalen Anordnungswinkel um die Flächennormale der Einkoppelfläche **12** herum angeordnet vorliegen, der sich um 180° unterscheidet. Somit handelt es sich auch hier um zwei gegenüberliegende Edge-Lit Anordnungen **11,** welche in einem gemeinsamen monolithischen Bauteil **13** angeordnet sind. Es wird für diese Ausführungsform ebenfalls eine Blende **8** seitlich der Einkoppelfläche **5** gezeigt.

**Figur 8** zeigt eine Querschnittsansicht der zweiten, beanspruchten Ausführungsform mit zwei Kanälen mit einem ersten eingeschalteten Kanal. Auch in dieser Darstellung wird der steilere Winkel der eingekoppelten Lichtstrahlung **15** deutlich, welcher sich in einem kleinerem Polarwinkel **14** mit der Flächennormalen der Auskoppelfläche **12** niederschlägt, unter dem die Auskoppelfläche **9** ausgehend von der Reflektionsfläche **7** beleuchtet wird. Durch die dadurch ermöglichte, günstigere Strahlführung kann das Bauteil **13** kompakter gehalten werden. Gleichzeitig wird durch die Anordnung der Lichtquelle **3** oberhalb der Anordnungsebene der Einkoppelfläche **22** die Bauhöhe nur geringfügig erhöht, da der vertikale Abstand zur Anordnungsebene **22** unter Beachtung des von der Lichtquelle **3** ausgehenden Strahlengangs so gering wie möglich gehalten wird. Die laterale Ausdehnung der Vorrichtung vergrößert sich durch die Anordnung der Lichtquelle entlang des Randbereichs der seitlichen Außenfläche überhaupt nicht. Der Abstand der Lichtquelle **3** gegenüber der ihr zugeordneten Einkoppelfläche **5** kann jedoch deutlich vergrößert werden. So ergeben sich insgesamt sehr gute Strahleigenschaften, welche für eine hohe optische Qualität der Leuchtfunktion sorgen, ohne die Abmessungen der Vorrichtung **1** negativ zu beeinflussen. Der Polarwinkel **14** wird entgegen dem Uhrzeigersinn positiv gelesen und beträgt somit -Θ. Es wird für diese Ausführungsform ebenfalls ein Blendenelement **8** gezeigt, welches unerwünschte Einstrahlung der Lichtquelle **3** in das Bauteil **15** vermindert.

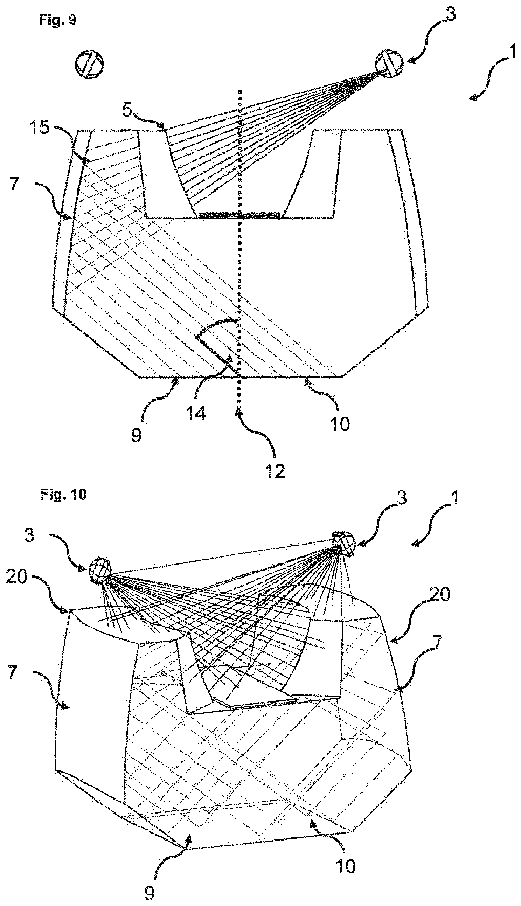

**Figur 9** zeigt eine Querschnittsansicht der zweiten, beanspruchten Ausführungsform mit zwei Kanälen mit einem zweiten eingeschalteten Kanal. Der Polarwinkel **14** zwischen der reflektiven Beleuchtung und der Flächennormalen der Auskoppelfläche 12 beträgt +Θ.

**Figur 10** zeigt eine zweite perspektivische Ansicht der zweiten, beanspruchten Ausführungsform der Vorrichtung 1 mit zwei Kanälen.

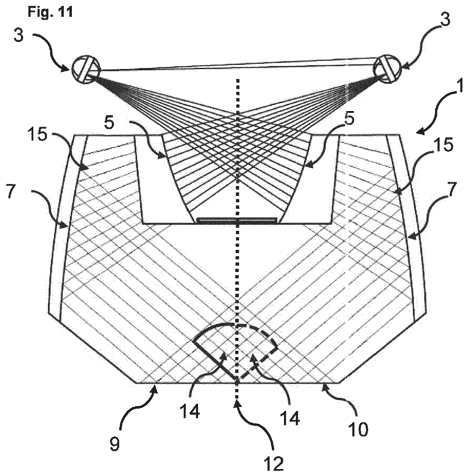

**Figur 11** zeigt eine Querschnittsansicht der zweiten, beanspruchten Ausführungsform mit beiden Kanälen eingeschaltet. Die Beleuchtung der zwei gegenüberliegenden Kanäle kann von den jeweiligen holografischen Strukturen **10** (nicht einzeln gezeigt) gut getrennt werden, da die Beleuchtung unter unterschiedlichen Polarwinkeln **14** von +Θ (Licht vom linken Kanal) und -Θ (Licht vom rechten Kanal) auf die Auskoppelfläche 9 trifft.

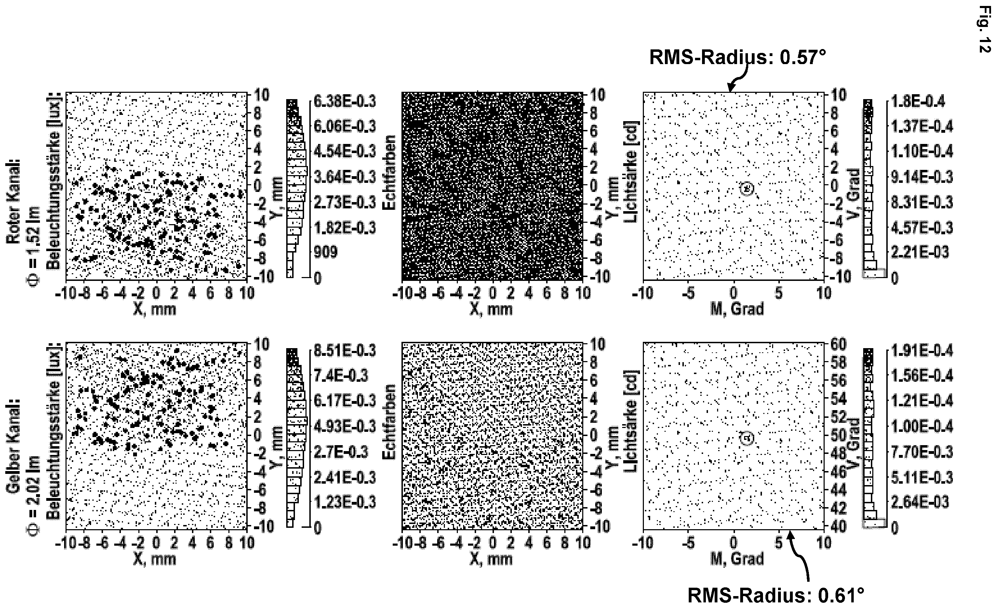

**Figur 12** zeigt eine Vermessung verschiedener Messgrößen der Leuchtfunktion beider Kanäle der Vorrichtung gemäß der zweiten, beanspruchten Ausführungsform. Die Erklärungen zur Figur 5 bzw. 6, z. B. zu den jeweils pro Graph gezeigten Größen, sind mutatis mutandis auch hier gültig. Dabei erzeugen wie vorstehend die beiden Kanäle Leuchtfunktionen in unterschiedlichen Farben. Ein erster Kanal erzeugt eine holographische Anzeige in rot und wird gemäß Abbildung als "roter Kanal" bezeichnet. Ein zweiter Kanal erzeugt eine holographische Anzeige in gelb und wird fortan gemäß Abbildung als "gelber Kanal" bezeichnet.

Die beiden unteren linken und rechten Grafen bilden die Beleuchtungsstärke in Lux (lux, Ix) des "roten Kanals" (linke Seite unten) und des "gelben Kanals" (rechte Seite unten) ab. Hier zeigt sich die Homogenität der Ausleuchtung vorteilhafterweise noch einmal verbessert. In weiten Teilen (außer punktuell) sind die Beleuchtungsstärken kleiner als 4,54E-0,3 und liegen im Bereich von 3,64E-0,3. In diesen Bereichen gilt im Wesentlichen überall Iₘᵢₙ/Iₘₐₓ > 0.8. Es ist somit eine weitgehend homogene Ausleuchtung erkennbar. Aus der Darstellung lässt sich vorzugsweise das Winkelspektrum und das Maß der Kollimation bestimmen. Der RMS-Radius des linken, roten Kanals beträgt 0,57° und der RMS-Radius des rechten, gelben Kanals beträgt 0,61°. Bis auf beim Maximum bei etwa 0° ist die Intensität sehr niedrig und es sind keine Nebenmaxima ersichtlich. Dies belegt die optimale Strahlführung auch dieser Ausführungsform der Vorrichtung.

Die beiden mittleren linken und rechten Grafen stellen durch ein entsprechendes schwarz-weißes Punktemuster die Echtfarben der Kanäle dar. Es ist hier vorteilhaftweise die hohe farbliche Homogenität des "roten Kanals" (links) und des "gelben Kanals" (rechts) erkennbar. Dies ist insbesondere bemerkenswert, da beide Kanäle über eine großflächige Auskopplung der gleichen Auskoppelfläche 9 realisiert werden. Somit ist bevorzugt ebenso ersichtlich, wie gut die Kanäle getrennt werden können.

Die beiden oberen Grafen bilden die gemessene Lichtstärke des "roten Kanals" (links) und des "gelben Kanals" (rechts) ab. Aus der Darstellung lässt sich das Winkelspektrum und das Maß der Kollimation bestimmen. Der RMS-Radius des linken, roten Kanals beträgt 0,57° und der RMS-Radius des rechten, gelben Kanals beträgt 0,61°. Bis auf beim Maximum bei etwa 0° ist die Intensität sehr niedrig und es sind keine Nebenmaxima ersichtlich. Dies belegt die optimale Strahlführung auch dieser Ausführungsform der Vorrichtung.

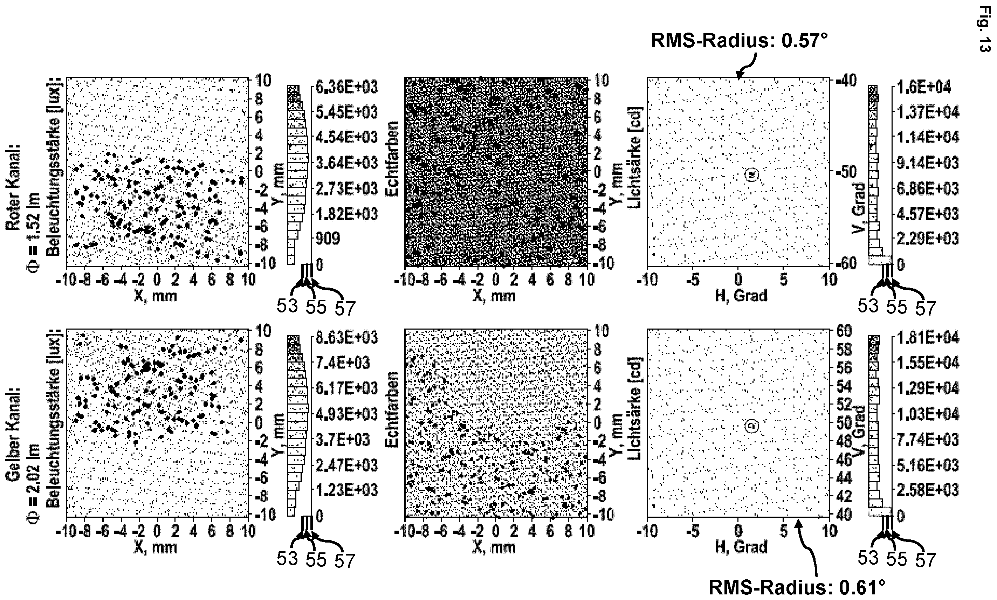

**Figur 13** zeigt eine zweite Vermessung bzw. eine Simulation verschiedener Messgrößen der Leuchtfunktion beider Kanäle der Vorrichtung gemäß der zweiten, beanspruchten Ausführungsform. Die Erklärungen zur Figur 5 bzw. 6, z. B. zu den jeweils pro Graph gezeigten Größen, sind mutatis mutandis auch hier gültig. Dabei erzeugen wie vorstehend die beiden Kanäle Leuchtfunktionen in unterschiedlichen Farben. Ein erster Kanal erzeugt eine holographische Anzeige in rot und wird gemäß Abbildung als "roter Kanal" bezeichnet. Ein zweiter Kanal erzeugt eine holographische Anzeige in gelb und wird fortan gemäß Abbildung als "gelber Kanal" bezeichnet.

Die beiden unteren linken und rechten Grafen bilden die Beleuchtungsstärke in Lux (lux, Ix) des "roten Kanals" (linke Seite unten) und des "gelben Kanals" (rechte Seite unten) ab. Hier zeigt sich die Homogenität der Ausleuchtung vorteilhafterweise noch einmal verbessert. In weiten Teilen (außer punktuell) sind die Beleuchtungsstärken nicht größer als 4,54E+0,3 und weisen vorteilhafterweise eine hohe Homogenität auf, insbesondere gilt im Wesentlichen überall Iₘᵢₙ/Iₘₐₓ > 0.8. Es ist somit eine weitgehend homogene Ausleuchtung erkennbar.

Die beiden mittleren linken und rechten Grafen stellen durch ein entsprechendes schwarz-weißes Punktemuster die Echtfarben der Kanäle dar. Es ist hier vorteilhaftweise die hohe farbliche Homogenität des "roten Kanals" (links) und des "gelben Kanals" (rechts) erkennbar. Dies ist insbesondere bemerkenswert, da beide Kanäle über eine großflächige Auskopplung der gleichen Auskoppelfläche 9 realisiert werden. Somit ist bevorzugt ebenso ersichtlich, wie gut die Kanäle getrennt werden können.

Die beiden oberen Grafen bilden die gemessene Lichtstärke des "roten Kanals" (links) und des "gelben Kanals" (rechts) ab. Aus der Darstellung lässt sich das Winkelspektrum und das Maß der Kollimation bestimmen. Der RMS-Radius des linken, roten Kanals beträgt 0,57° und der RMS-Radius des rechten, gelben Kanals beträgt 0,61°. Bis auf beim Maximum bei etwa 0° ist die Intensität sehr niedrig und es sind keine Nebenmaxima ersichtlich. Dies belegt die optimale Strahlführung auch dieser Ausführungsform der Vorrichtung.

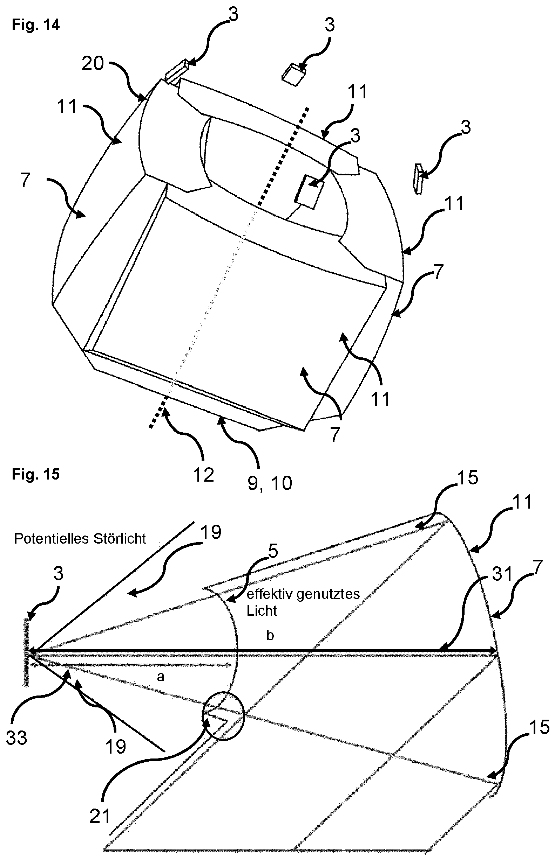

**Figur 14** zeigt eine perspektivische Ansicht der Vorrichtung 1 gemäß der zweiten, beanspruchten Ausführungsform und vier Kanälen. Hier sind vier Edge-Lit Anordnungen um die Flächennormale der Auskoppelfläche 12 in einer ringartigen Anordnung entlang vierer azimutaler Anordnungswinkel angeordnet, welche sich um jeweils 90° unterscheiden. Die jeweiligen Lichtquellen **3** sind äquivalent entlang des Randbereichs der seitlichen Außenfläche **20** angeordnet. Es gibt vorzugsweise einen (nicht gezeigten) ersten und einen (nicht gezeigten) zweiten konzentrischen Kreis um die Flächennormale der Auskoppelfläche **12,** wobei die Einkoppelflächen **5** vom ersten Kreis in einem einzigen Punkt berührt werden und die Reflektionsflächen **7** vom zweiten Kreis in einem einzigen Punkt berührt werden. Die Lichtquellen **3** sind ebenfalls bevorzugt entlang eines dritten konzentrischen Kreises angeordnet.

**Figur 15** verdeutlich anhand einer schematischen Ansicht die Auswirkung der Abstände der verschiedenen Elemente der Anordnung auf den Strahlenverlauf. Durch den gewählten Abstand **33** zwischen Lichtquelle **3** und Einkoppelfläche **5** kann das Winkelspektrum der Lichtquelle **18,** welches in die Edge-Lit Anordnung **11** eingekoppelt wird, verringert werden gegenüber einem geringeren Abstand. Für das Winkelspektrum der Beleuchtung der Auskoppelfläche **9** ist der Abstand **31** von Bedeutung, da im gezeigten Ausführungsbeispiel die Reflektionsfläche **7** für das Auffangen des Lichtes und die Kollimation der Strahlen wesentlich ist. Die äußeren Grenzflächen des Bauteils sind vorzugsweise an den Strahlverlauf des eingekoppelten Lichts **15** angepasst, so das unerwünschte Totalreflektionen des eingekoppelten Lichts **15** verhindert werden können. Ein Abstand **31** zwischen Lichtquelle **3** und Reflektionsfläche **7** ist in dem gezeigten Ausführungsbeispiel vorzugsweise so bemessen, dass eine Kollimation der in Richtung der Auskoppelfläche reflektierten Strahlen erzielt werden kann. Hierfür ist wie beschrieben ein eher großer Abstand zu bevorzugen, wodurch vorteilhafterweise die Lichtquelle **3** für die Reflektionsfläche **7** als Punktlichtquelle angenähert werden kann. Abstand **33** wird dann vorzugsweise so gewählt, dass die Differenz zwischen Abstand **31** und Abstand **33** minimal wird, ohne die Strahlen zu beschneiden, z. B. an der Schnittkante **21.** Es können neben einer Kollimation der Strahlen auch andere Arten der Strahlformung bevorzugt sein. Bei der Formgebung werden vorzugsweise auch potentielle Schnittkanten **21** für die Lichtbündel berücksichtigt und vorteilhafterweise minimiert.

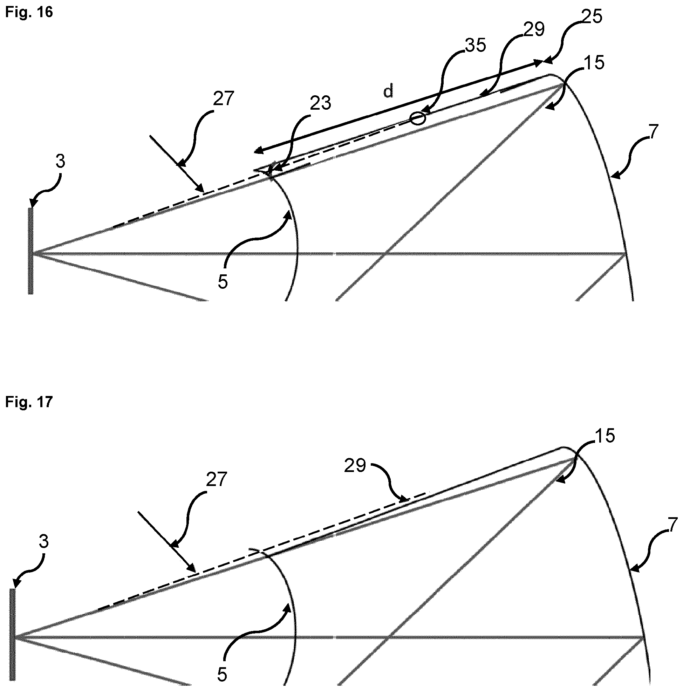

**Figur 16** zeigt schematisch eine Ausführungsform der Vorrichtung 1 mit einer Verrundung **23** an einer Außenkante der Einkoppelfläche **5.** Da Einkoppel- **5** und Reflektionsfläche **7** einen Abstand zueinander aufweisen, hat auch die Oberseite bzw. (obere) Verbindungsfläche **29** zwischen Einkoppelfläche **5** und Reflektionsfläche **7** eine endliche Ausdehnung d, an der Strahlen totalreflektiert werden können **35.** Um diese Strahlen abzuschatten bzw. gezielt zu streuen, können vorzugsweise Verrundungen **23** an Außenkanten der Einkoppelfläche **5** eingeführt werden. So können Lichtstrahlen im Grenzbereich des einkoppelbaren Winkelspektrums **27,** welche für solche unerwünschte Totalreflektionen sorgen könnten, gezielt in unproblematische Richtungen gestreut bzw. gebeugt werden.

**Figur 17** zeigt schematisch eine Ausführungsform der Vorrichtung mit einer verkippten Verbindungsfläche **29** zwischen Einkoppelfläche **5** und Reflektionsfläche **7.**

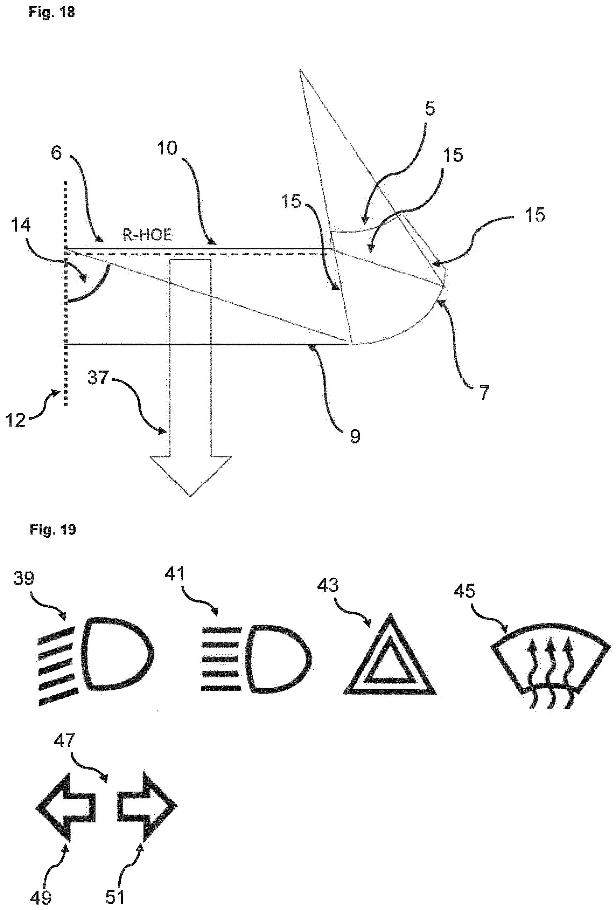

Dies stellt eine alternative Möglichkeit dar, um unerwünschte Totalreflektionen zu verhindern, die durch Lichtstrahlen im Grenzbereich des einkoppelbaren Winkelspektrums **27** verursacht werden könnten. Die Verbindungsfläche **29** ist auf eine Weise ausgehend von der Einkoppelfläche **5** "nach oben" verkippt, dass es ebenfalls zu keinen unerwünschten Reflektionen kommen kann. Während die vorher gezeigten Abbildungen Ausführungsbeispiele mit auf der Auskoppelfläche vorliegenden transmissiven holografischen Strukturen darstellten zeigt Figur 18 schematisch eine reflektive holographische Struktur **10**, die nicht auf der Auskoppelfläche **9,** sondern auf einer zu dieser parallelen Fläche 6 angeordnet ist, welcher der Auskoppelfläche **9** gegenüberliegt. Es ist zu erkennen, dass diese Struktur ebenfalls unter einem Polarwinkel **14** beleuchtet wird, welcher zwischen der Flächennormalen der Auskoppelfläche **12** und der Richtung der Beleuchtungsstrahlen gemessen wird. Das von der holografischen Struktur in Richtung der Auskoppelfläche 9 gebeugte Licht 37 wird durch diese ausgekoppelt. Es kann erkannt werden, dass für dieses Beispiel die Einstrahlungsrichtung des Lichtes in die Einkoppelfläche **5** steiler ist und die Reflektionsfläche **7** anders angeordnet ist, damit das eingekoppelte Licht **15** in Richtung der holografischen Struktur und nicht der Auskoppelfläche **9** reflektiert wird.

**Figur 19** zeigt mögliche angezeigte Elemente bei einer Verwendung der holographischen Leuchtvorrichtung zu einer Anzeige mindestens einer von mehreren möglichen Informationen für ein Bedienelement in einem Fahrzeug. Dabei kann beispielsweise ein Anzeigenelement realisiert werden, welches Informationen über verschiedene Zustände des Fahrzeugs oder von Komponenten des Fahrzeugs ausgibt. Beispiele sind die hier gezeigten Anzeigen bzw. angezeigten Elemente gemäß 78/316/EWG, z. B. eine Anzeige für das Abblendlicht **39,** eine Anzeige für das Fernlicht **41,** eine Anzeige für die Warnblinkanlage **43,** eine Anzeige für die Windschutzscheibenentfeuchtungs- und Entfrostungsanlage **45** und/oder eine Anzeige für den Blinker **47.** Die Anzeigen können je nach dem jeweils von einer eigenen Leuchtvorrichtung angezeigt werden oder von einer einzigen Leuchtvorrichtung. Es kann in diesem Fall auch möglich sein, dass mehrere Elemente gleichzeitig gezeigt werden, z. B. in dem diese auf der Auskoppelfläche in räumlich getrennten Bereichen angezeigt werden. Bei dem Blinker kann spezifisch durch eine Leuchtvorrichtung angezeigt werden, ob der Blinker links (Anzeige Blinker links **49)** oder der Blinker rechts (Anzeige Blinker rechts **51)** betätigt wurde. Die Anzeige kann holographische 3-D Effekte aufweisen oder aber standardmäßig zweidimensional erscheinen.

Die vorgenannten Beispiele betreffen vorzugsweise einfarbige Anzeigen. Es kann jedoch ebenso bei bestimmten Anzeigen bevorzugt sein, dass die Anzeige je nach Zustand die Farbe wechselt, bspw. von rot (angezeigte Funktion ist ausgeschaltet) zu grün (angezeigte Funktion ist eingeschaltet). Dies ist dann vorteilhafterweise ebenfalls durch eine einzige Leuchtvorrichtung wie hierin beschrieben realisierbar.

### BEZUGSZEICHENLISTE

- 1: Holographische Leuchtvorrichtung
- 3: Lichtquelle
- 5: Einkoppelfläche
- 6: Zur Auskoppelfläche parallele bzw. der Auskoppelfläche gegenüberliegende Fläche
- 7: Reflektionsfläche
- 8: Blendenelement
- 9: Auskoppelfläche
- 10: Holografische Struktur
- 11: Edge-Lit Anordnung
- 12: Flächennormale zur Auskoppelfläche
- 13: Monolithisches Bauteil
- 14: Polarwinkel
- 15: Eingekoppelte Lichtstrahlen
- 16: Anordnungsrichtung der Kanäle
- 17: Teilweise offener Innenbereich
- 18: Azimutaler Anordnungswinkel
- 19: Winkelspektrum der Lichtquelle
- 20: Randbereich der seitlichen Außenfläche
- 21: Schnittkante für Lichtbündel
- 22: Anordnungsebene der Einkoppelflächen
- 23: Verrundung
- 25: Abstand zwischen Einkoppelfläche und Reflektionsfläche
- 27: Lichtstrahlen im Grenzbereich des einkoppelbaren Winkelspektrums
- 29: (Versetzte) Verbindungsfläche zwischen Einkoppelfläche und Reflektionsfläche
- 31: Abstand zwischen Lichtquelle und Reflektionsfläche
- 33: Abstand zwischen Lichtquelle und Einkoppelfläche
- 35: Unerwünschte Reflektion an einer Verbindungsfläche zwischen Einkoppelfläche und Reflektionsfläche
- 37: Lichtstrahlen zur Erzeugung der Leuchtfunktion
- 39: Anzeige Abblendlicht
- 41: Anzeige Fernlicht
- 43: Anzeige Warnblinkanlage
- 45: Anzeige Windschutzscheibenentfeuchtungs- und Entfrostungsanlage
- 47: Anzeige Blinker
- 49: Anzeige Blinker links
- 51: Anzeige Blinker rechts
- 53: Skalenbeschriftung mit Wert ,1'
- 55: Skalenbeschriftung mit Wert ,10'
- 57: Skalenbeschriftung mit Wert ,100'

## Patentansprüche

1. Holographisches Leuchtvorrichtung (1) zur Erzeugung mindestens zweier holographischer Leuchtfunktionen, aufweisend mindestens zwei Kanäle für die jeweils zugeordnete Leuchtfunktion, wobei jeder Leuchtfunktion ein Kanal zugeordnet wird, wobei jeder Kanal folgende Komponenten umfasst:
- eine Edge-Lit-Anordnung (11), aufweisend folgende Elemente:
∘ eine Einkoppelfläche (5) für eine Einkopplung von Licht einer Lichtquelle (3) in die Edge-Lit-Anordnung (11) und
∘ eine Auskoppelfläche (9)
- die Lichtquelle (3), angeordnet für eine Einstrahlung in die Einkoppelfläche (5)
wobei die Edge-Lit-Anordnungen (11) der Kanäle in einem monolithischen Bauteil (13) umfasst sind und die Auskoppelfläche (9) eine gemeinsame Auskoppelfläche ist,
wobei jeder Kanal entlang eines azimutalen Anordnungswinkels (18) um eine Flächennormale der Auskoppelfläche (12) angeordnet vorliegt und
wobei das monolithische Bauteil (13) mindestens eine zur Auskoppelfläche überwiegend parallele holografische Struktur (10) aufweist, welche eingerichtet ist für eine Erzeugung der Leuchtfunktion des jeweiligen Kanals unter einer Beleuchtung durch die Lichtquelle (3) des Kanals,
wobei die Edge-Lit-Anordnung (11) jedes Kanals als weiteres Element eine Reflektionsfläche (7) aufweist, welche eingerichtet ist für eine direkte reflektive Beleuchtung der holografischen Struktur (10) durch eingekoppeltes Licht (15),
wobei die Lichtquelle (3) auf einer gegenüberliegenden Seite der Flächennormalen der Auskoppelfläche (12) wie die ihr zugeordnete Einkoppelfläche (5) angeordnet vorliegt,
wobei die Flächennormale die Auskoppelfläche (12) im geometrischen Schwerpunkt der Auskoppelfläche (12) berührt bzw. schneidet.

2. Holographisches Leuchtvorrichtung (1) nach Anspruch 1,
**dadurch gekennzeichnet, dass**
die Reflektionsfläche eingerichtet ist für eine direkte reflektive Beleuchtung der holografischen Struktur (10) entlang des azimutalen Anordnungswinkels,
wobei die holografische Struktur (10) eingerichtet ist für die Erzeugung der Leuchtfunktion des Kanals bei der reflektiven Beleuchtung entlang des azimutalen Anordnungswinkels (18).

3. Holographisches Leuchtvorrichtung (1) nach dem vorherigen Anspruch,
**dadurch gekennzeichnet, dass**
die Reflektionsfläche (7) eingerichtet ist für eine direkte reflektive Beleuchtung der holografischen Struktur (10) durch eingekoppeltes Licht in einem Polarwinkel (14) in Bezug auf die Flächennormale der Auskoppelfläche (12),
wobei die holografische Struktur (10) bevorzugt eingerichtet ist für die Erzeugung der Leuchtfunktion bei einer Beleuchtung in dem Polarwinkel (14).

4. Holographisches Leuchtvorrichtung (1) nach einem der vorherigen Ansprüche,
**dadurch gekennzeichnet, dass**
die Auskoppelfläche (9) die holografische Struktur aufweist,
wobei die holografische Struktur (10) eine transmissive holografische Struktur ist,
wobei Lichtquelle (3) und Edge-Lit Anordnung (11) eingerichtet sind für die Beleuchtung der Auskoppelfläche (9) unter dem Polarwinkel (14) in Bezug auf die Flächennormale der Auskoppelfläche (12) größer als ein kritischer Winkel der Totalreflektion.

5. Holographische Leuchtvorrichtung (1) nach einem der vorherigen Ansprüche 1-3,
**dadurch gekennzeichnet, dass**
eine zur Auskoppelfläche parallele Fläche (6) die holografische Struktur (10) aufweist, wobei die holografische Struktur (10) eine reflektive holografische Struktur ist.

6. Holographisches Leuchtvorrichtung (1) nach einem oder mehreren der vorherigen Ansprüche,
**dadurch gekennzeichnet, dass**
die Reflektionsflächen (7) so angeordnet sind, dass sie mindestens eine seitliche Außenfläche des monolithischen Bauteils (13) zumindest teilweise bilden und
die Einkoppelflächen (5) in Richtung eines Inneren des monolithischen Bauteils (13) angeordnet sind,
wobei sie so angeordnet sind, dass sie einen teilweise offenen Innenbereich (17) des monolithischen Bauteils (13) zumindest bereichsweise seitlich umschließen.

7. Holographisches Leuchtvorrichtung (1) nach einem oder mehreren der vorherigen Ansprüche 3-6,
**dadurch gekennzeichnet, dass**
zwei gegenüberliegende Kanäle zueinander eine Abweichung eines Betrages des Polarwinkels (14) aufweisen,
vorzugsweise zwischen 1° und 10°.

8. Holographisches Leuchtvorrichtung (1) nach Anspruch 6 oder nach Anspruch 7 in Verbindung mit Anspruch 6,
**dadurch gekennzeichnet, dass**
die Lichtquelle (3) außerhalb des Innenbereichs (17) des monolithischen Bauteils (13) angeordnet vorliegt,
insbesondere entlang eines Randbereichs der seitlichen Außenfläche (20) des monolithischen Bauteils (13).

9. Holographisches Leuchtvorrichtung (1) nach einem oder mehreren der vorherigen Ansprüche,
**dadurch gekennzeichnet, dass**
die Lichtquelle (3) oberhalb einer zur Flächennormalen der Auskoppelfläche (12) senkrechten Anordnungsebene der Einkoppelflächen (22) angeordnet ist und
bevorzugt eingerichtet ist für eine Einstrahlung in die ihr zugeordnete Einkoppelfläche (5) in einem Winkel zur Anordnungsebene der Einkoppelflächen (22).

10. Holographisches Leuchtvorrichtung (1) nach einem oder mehreren der vorherigen Ansprüche,
**dadurch gekennzeichnet, dass**
die Reflektionsfläche (7) einen Parabolspiegel umfasst, dessen Brennebene bevorzugt mit einer Emitterfläche der Lichtquelle (3) zusammenfällt,
wobei vorzugsweise die Emitterfläche der Lichtquelle (3) eine Ausdehnung bis zu 1 x 1 mm² aufweist und die Lichtquelle (3) und die zugeordnete Reflektionsfläche (7) einen Abstand von mindestens 20 mm aufweisen

11. Holographisches Leuchtvorrichtung (1) nach einem oder mehreren der vorherigen Ansprüche,
**dadurch gekennzeichnet, dass**
die holografische Struktur (10) eingerichtet ist für eine Erzeugung eines identischen Bildes für jeden Kanal,
wobei die Leuchtfunktion einer einstellbaren Helligkeit des Bildes entspricht.

12. Holographisches Leuchtvorrichtung (1) nach einem oder mehreren der vorherigen Ansprüche,
**dadurch gekennzeichnet, dass**
die holografische Struktur (10) eingerichtet ist für eine Strahlformung von Lichtstrahlen des Kanals,
wobei die Strahlformung vorzugsweise ausgesucht ist aus der Gruppe Kollimation, Fokussierung und/oder Zerstreuung.

13. Fahrzeug umfassend mindestens eine holographische Leuchtvorrichtung (1) nach einem oder mehreren der vorherigen Ansprüche 1 - 12, **dadurch gekennzeichnet, dass**
die holographische Leuchtvorrichtung (1) eingerichtet ist zu einer Anzeige mindestens einer von mehreren möglichen Informationen betreffend eine Fahrsituation, wobei eine Information einem Kanal der holographische Leuchtvorrichtung (1) zugeordnet ist wobei die holographische Leuchtvorrichtung (1) bevorzugt in einer A-Säule, einer B-Säule und/oder einer C-Säule des Fahrzeugs angeordnet vorliegt
wobei die holographische Leuchtvorrichtung (1) insbesondere eine Anzeige eines Spurwechselassistenten umfasst.

14. Verwendung einer holographischen Leuchtvorrichtung (1) nach einem oder mehreren der vorherigen Ansprüche 1 - 12 zu einer Anzeige mindestens einer von mehreren möglichen Informationen, insbesondere in einem Fahrzeug betreffend eine Fahrsituationen,
wobei die Information einem Kanal der holographische Leuchtvorrichtung (1) zugeordnet ist und
wobei zur Anzeige der Information eine Beleuchtung der holografischen Struktur (10) durch die dem Kanal zugeordnete Lichtquelle (3) vorgenommen wird.

15. Verwendung einer holographischen Leuchtvorrichtung (1) gemäß Anspruch 12 als LED-Kollimator, insbesondere für eine messtechnische Anwendung und/oder Vorrichtung.

## Claims

1. Holographic lighting device (1) for producing at least two holographic lighting functions, having at least two channels for the respective assigned lighting function, with each lighting function being assigned one channel and each channel comprising the following component parts:
- an edge-lit arrangement (11), having the following elements:
o an input coupling surface (5) for coupling light from a light source (3) into the edge-lit arrangement (11) and
o an output coupling surface (9)
- the light source (3), arranged to radiate into the input coupling surface (5),
wherein
the edge-lit arrangements (11) of the channels are encompassed in a monolithic component (13) and the output coupling surface (9) is a joint output coupling surface, wherein each channel is arranged about a surface normal of the output coupling surface (12) along an azimuthal arrangement angle (18) and
wherein the monolithic component (13) has at least one holographic structure (10) predominantly parallel to the output coupling surface and configured for producing the lighting function of the respective channel under illumination by the light source (3) of the channel, wherein, as a further element, the edge-lit arrangement (11) of each channel has a reflection surface (7) which is configured for direct reflective illumination of the holographic structure (10) with input-coupled light (15), wherein the light source (3) is arranged on an opposite side of the surface normal of the output coupling surface (12) to the input coupling surface (5) assigned thereto, wherein the surface normal touches/intersects the output coupling surface (12) at the geometric centre of gravity of the output coupling surface (12).

2. Holographic lighting device (1) according to Claim 1,
**characterized in that**
the reflection surface is configured for direct reflective illumination of the holographic structure (10) along the azimuthal arrangement angle,
wherein the holographic structure (10) is configured for producing the lighting function of the channel in the case of the reflective illumination along the azimuthal arrangement angle (18).

3. Holographic lighting device (1) according to the preceding claim,
**characterized in that**
the reflection surface (7) is configured for direct reflective illumination of the holographic structure (10) by input-coupled light at a polar angle (14) in relation to the surface normal of the output coupling surface (12),
wherein the holographic structure (10) preferably is configured for producing the lighting function in the case of an illumination at the polar angle (14).

4. Holographic lighting device (1) according to any of the preceding claims,
**characterized in that**
the output coupling surface (9) has the holographic structure,
wherein the holographic structure (10) is a transmissive holographic structure,
wherein the light source (3) and edge-lit arrangement (11) are configured for illumination of the output coupling surface (9) at the polar angle (14) in relation to the surface normal of the output coupling surface (12) that is greater than a critical angle of total-internal reflection.

5. Holographic lighting device (1) according to any of preceding Claims 1-3,
**characterized in that**
a surface (6) parallel to the output coupling surface has the holographic structure (10), wherein the holographic structure (10) is a reflective holographic structure.

6. Holographic lighting device (1) according to one or more of the preceding claims,
**characterized in that**
the reflection surfaces (7) are arranged in such a way that they at least partly form at least one lateral outer surface of the monolithic component (13) and
the input coupling surfaces (5) are arranged in the direction of an interior of the monolithic component (13),
wherein they are arranged in such a way that they laterally enclose a partly open inner region (17) of the monolithic component (13) in at least one region.

7. Holographic lighting device (1) according to one or more of preceding Claims 3-6,
**characterized in that**
two opposing channels have a deviation from one another by an absolute value of the polar angle (14), preferably between 1° and 10°.

8. Holographic lighting device (1) according to Claim 6 or according to Claim 7 in conjunction with Claim 6,
**characterized in that**
the light source (3) is located outside of the inner region (17) of the monolithic component (13),
in particular along an edge region of the lateral outer surface (20) of the monolithic component (13).

9. Holographic lighting device (1) according to one or more of the preceding claims,
**characterized in that**
the light source (3) is arranged above an arrangement plane of the input coupling surfaces (22) which is perpendicular to the surface normal of the output coupling surface (12), and
is preferably configured for radiating into the input coupling surface (5) assigned thereto, at an angle with respect to the arrangement plane of the input coupling surfaces (22).

10. Holographic lighting device (1) according to one or more of the preceding claims,
**characterized in that**
the reflection surface (7) comprises a parabolic mirror, the focal plane of which preferably coincides with an emitter surface of the light source (3),
wherein the emitter surface of the light source (3) preferably has an extent of up to 1 x 1 mm² and the light source (3) and the reflection surface (7) assigned thereto have a distance of at least 20 mm.

11. Holographic lighting device (1) according to one or more of the preceding claims,
**characterized in that**
the holographic structure (10) is configured for producing an identical image for each channel,
wherein the lighting function corresponds to an adjustable brightness of the image.

12. Holographic lighting device (1) according to one or more of the preceding claims,
**characterized in that**
the holographic structure (10) is configured for a beam shaping of light beams of the channel,
wherein the beam shaping is preferably selected from the group of collimation, focusing and/or divergence.

13. Vehicle comprising at least one holographic lighting device (1) according to one or more of preceding Claims 1-12,
**characterized in that**
the holographic lighting device (1) is configured to display at least one of a plurality of possible information items relating to a driving situation, wherein one information item is assigned to a channel of the holographic lighting device (1),
wherein the holographic lighting device (1) is preferably arranged in an A pillar, a B pillar and/or a C pillar of the vehicle,
wherein the holographic lighting device (1) comprises a display of a lane change assist system in particular.

14. Use of a holographic lighting device (1) according to one or more of preceding Claims 1-12 for displaying at least one of a plurality of possible information items, in particular in a vehicle in relation to a driving situation,
wherein the information is assigned to a channel of the holographic lighting device (1) and
wherein, for the purpose of displaying the information, the holographic structure (10) is illuminated by the light source (3) assigned to the channel.

15. Use of a holographic lighting device (1) according to Claim 12 as an LED collimator, in particular for a metrological application and/or device.

## Revendications

1. Dispositif d'éclairage holographique (1) destiné à générer au moins deux fonctions d'éclairage holographique, possédant au moins deux canaux pour la fonction d'éclairage respectivement associée, un canal étant associé à chaque fonction d'éclairage, chaque canal comprenant les composants suivants :
- un arrangement à éclairage périphérique (11), possédant les éléments suivants :
o une surface de couplage d'entrée (5) pour une injection de la lumière d'une source de lumière (3) dans l'arrangement à éclairage périphérique (11), et
o une surface de couplage de sortie (9)
- la source de lumière (3), disposée pour un rayonnement incident dans la surface de couplage d'entrée (5),
les arrangements à éclairage périphérique (11) des canaux étant compris dans un composant monolithique (13) et la surface de couplage de sortie (9) étant une surface de couplage de sortie commune,
chaque canal se présentant en étant disposé le long d'un angle d'agencement azimutal (18) autour d'une surface normale à la surface de couplage de sortie (12) et
le composant monolithique (13) possédant au moins une structure holographique (10) principalement parallèle à la surface de couplage de sortie, laquelle est conçue pour générer la fonction d'éclairage du canal respectif sous un éclairage par la source de lumière (3) du canal, l'arrangement à éclairage périphérique (11) de chaque canal présentant comme élément supplémentaire une surface réfléchissante (7), laquelle est conçue pour un éclairage direct par réflexion de la structure holographique (10) par de la lumière injectée (15),
la source de lumière (3) se présentant en étant disposée sur un côté opposé à la normale à la surface de la surface de couplage de sortie (12), comme la surface de couplage d'entrée (5) qui lui est associée,
la normale à la surface touche ou croise la surface de couplage de sortie (12) dans le barycentre de la surface de couplage de sortie (12).

2. Dispositif d'éclairage holographique (1) selon la revendication 1,
**caractérisé en ce que**
la surface réfléchissante est conçue pour un éclairage direct par réflexion de la structure holographique (10) le long de l'angle d'agencement azimutal,
la structure holographique (10) étant conçue pour générer la fonction d'éclairage du canal lors de l'éclairage par réflexion le long de l'angle d'agencement azimutal (18).

3. Dispositif d'éclairage holographique (1) selon la revendication précédente,
**caractérisé en ce que**
la surface réfléchissante (7) est conçue pour un éclairage direct par réflexion de la structure holographique (10) par une lumière injectée à un angle polaire (14) par rapport à la normale à la surface de la surface de couplage de sortie (12),
la structure holographique (10) étant de préférence conçue pour générer la fonction d'éclairage lors d'un éclairage à l'angle polaire (14).

4. Dispositif d'éclairage holographique (1) selon l'une des revendications précédentes,
**caractérisé en ce que**
la surface de couplage de sortie (9) présente la structure holographique,
la structure holographique (10) étant une structure holographique transmissive,
la source de lumière (3) et l'arrangement à éclairage périphérique (11) étant conçus pour éclairer la surface de couplage de sortie (9) à un angle polaire (14) par rapport à la normale à la surface de la surface de couplage de sortie (12) qui est supérieur à un angle critique de réflexion totale.

5. Dispositif d'éclairage holographique (1) selon l'une des revendications précédentes 1 à 3,
**caractérisé en ce que**
une surface (6) parallèle à la surface de couplage de sortie présente la structure holographique (10), la structure holographique (10) étant une structure holographique réfléchissante.

6. Dispositif d'éclairage holographique (1) selon une ou plusieurs des revendications précédentes,
**caractérisé en ce que**
les surfaces réfléchissantes (7) sont disposées de telle sorte qu'elles forment au moins partiellement au moins une surface extérieure latérale du composant monolithique (13) et
les surfaces de couplage d'entrée (5) sont disposées en direction de l'intérieur du composant monolithique (13), celles-ci étant disposées de telle sorte qu'elles entourent latéralement au moins par portions une zone intérieure (17) partiellement ouverte du composant monolithique (13).

7. Dispositif d'éclairage holographique (1) selon une ou plusieurs des revendications précédentes 3 à 6,
**caractérisé en ce que**
deux canaux opposés présentent un écart d'une valeur absolue de l'angle polaire (14) l'un par rapport à l'autre,
de préférence entre 1° et 10°.

8. Dispositif d'éclairage holographique (1) selon la revendication 6 ou selon la revendication 7 en liaison avec la revendication 6,
**caractérisé en ce que**
la source de lumière (3) se présente en étant disposée à l'extérieur de la zone intérieure (17) du composant monolithique (13),
en particulier le long d'une zone de bordure de la surface extérieure latérale (20) du composant monolithique (13).

9. Dispositif d'éclairage holographique (1) selon une ou plusieurs des revendications précédentes,
**caractérisé en ce que**
la source de lumière (3) est disposée au-dessus d'un plan d'agencement des surfaces de couplage d'entrée (22) qui est perpendiculaire à la normale à la surface de la surface de couplage de sortie (12), et
est de préférence conçue pour un rayonnement incident dans la surface de couplage d'entrée (5) qui lui est associée selon un certain angle par rapport au plan d'agencement des surfaces de couplage d'entrée (22).

10. Dispositif d'éclairage holographique (1) selon une ou plusieurs des revendications précédentes,
**caractérisé en ce que**
la surface réfléchissante (7) comprend un miroir parabolique dont le plan focal coïncide de préférence avec une surface émettrice de la source de lumière (3),
la surface émettrice de la source de lumière (3) présentant de préférence une étendue allant jusqu'à 1 x 1 mm² et la source de lumière (3) et la surface réfléchissante (7) associée présentant un écart d'au moins 20 mm.

11. Dispositif d'éclairage holographique (1) selon une ou plusieurs des revendications précédentes,
**caractérisé en ce que**
la structure holographique (10) est conçue pour générer une image identique pour chaque canal,
la fonction d'éclairage correspondant à une luminosité réglable de l'image.

12. Dispositif d'éclairage holographique (1) selon une ou plusieurs des revendications précédentes,
**caractérisé en ce que**
la structure holographique (10) est conçue pour une mise en forme de faisceau des faisceaux lumineux du canal,
la mise en forme de faisceau étant de préférence choisie dans le groupe de collimation, focalisation et/ou dispersion.

13. Véhicule comprenant au moins un dispositif d'éclairage holographique (1) selon une ou plusieurs des revendications précédentes 1 à 12,
**caractérisé en ce que**
le dispositif d'éclairage holographique (1) est conçu pour afficher au moins une parmi une pluralité d'informations possibles concernant une situation de conduite, une information étant associée à un canal du dispositif d'éclairage holographique (1)
le dispositif d'éclairage holographique (1) se présentant de préférence disposé dans un montant A, un montant B et/ou un montant C du véhicule
le dispositif d'éclairage holographique (1) comprenant notamment un affichage d'un assistant de changement de voie.

14. Utilisation d'un dispositif d'éclairage holographique (1) selon une ou plusieurs des revendications précédentes 1 à 12 pour un affichage d'au moins une parmi une pluralité d'informations possibles, en particulier dans un véhicule concernant une situation de conduite,
l'information étant associée à un canal du dispositif d'éclairage holographique (1) et
un éclairage de la structure holographique (10) par la source de lumière (3) associée au canal étant effectué en vue de l'affichage de l'information.

15. Utilisation d'un dispositif d'éclairage holographique (1) selon la revendication 12 en tant que collimateur à LED, en particulier pour une application et/ou un dispositif métrologiques.
